(19) Europäisches Patentamt
European Patent Office
Office européen des brevets

(11) **EP 3 293 854 B1**

(12) **EUROPÄISCHE PATENTSCHRIFT**

(45) Veröffentlichungstag und Bekanntmachung des Hinweises auf die Patenterteilung:
**08.01.2020  Patentblatt 2020/02**

(51) Int Cl.:
*H02J 13/00* (2006.01)          *H02H 7/26* (2006.01)
*H02H 1/00* (2006.01)          *H02J 3/00* (2006.01)
*G01R 31/08* (2006.01)          *H02H 3/04* (2006.01)
*H02H 3/07* (2006.01)

(21) Anmeldenummer: **16188456.4**

(22) Anmeldetag: **13.09.2016**

(54) **VERFAHREN ZUM ERMITTELN EINER URSACHE EINES FEHLERS IN EINEM ELEKTRISCHEN ENERGIEVERSORGUNGSNETZ UND SCHUTZGERÄT ZUR DURCHFÜHRUNG EINES SOLCHEN VERFAHRENS**

METHOD FOR DETERMINING A CAUSE OF AN ERROR IN AN ELECTRICAL ENERGY SUPPLY SYSTEM AND PROTECTION DEVICE FOR CARRYING OUT SAID METHOD

PROCÉDÉ DE DÉTERMINATION DE L'ORIGINE D'UNE PANNE SUR UN RÉSEAU D'ALIMENTATION ÉLECTRIQUE ET APPAREIL DE PROTECTION POUR RÉALISER UN TEL PROCÉDÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**14.03.2018  Patentblatt 2018/11**

(60) Teilanmeldung:
**18000793.2 / 3 457 522**

(73) Patentinhaber: **Siemens Aktiengesellschaft**
**80333 München (DE)**

(72) Erfinder:
• **Erkens, Ingo**
  **90518 Altdorf-Röthenbach (DE)**
• **Werner, Thomas**
  **91126 Rednitzhembach (DE)**
• **Dzienis, Cezary**
  **14624 Dallgow-Döberitz (DE)**
• **Kereit, Matthias**
  **12159 Berlin (DE)**
• **Yelgin, Yilmaz**
  **13589 Berlin (DE)**

(56) Entgegenhaltungen:
WO-A1-95/09463          WO-A1-97/36185
WO-A1-2012/003888          DE-C1- 4 433 406
US-A1- 2012 176 712

• **BOEHME K ET AL: "OPTIMIERUNG VON DISTANZSCHUTZ-ALGORITHMEN MIT HILFE NEURONALER NETZE", ELEKTRIE, VEB VERLAG TECHNIK. BERLIN, DD, Bd. 47, Nr. 1, 1. Januar 1993 (1993-01-01) , Seiten 2-10, XP000335613, ISSN: 0013-5399**
• **Lehrstuhl für Hochspannungs- und Anlagentechnik: "Hochspannungstechnik - Skript zur Vorlesung SS 2009", März 2009 (2009-03), Technische Universität München, XP002767350, Seiten 75-93, * das ganze Dokument ***

**Beschreibung**

Die Erfindung betrifft Verfahren zum Ermitteln einer Ursache eines Fehlers in einem elektrischen Energieversorgungsnetz, bei dem an mindestens einer Messstelle des Energieversorgungsnetzes elektrische Messgrößen erfasst werden, und die elektrischen Messgrößen mindestens einem Schutzgerät zugeführt werden, das die Messgrößen hinsichtlich des Vorliegens eines Fehlers in dem elektrischen Energieversorgungsnetz untersucht und im Falle eines erkannten Fehlers ein Fehlersignal erzeugt, wobei nach der Erkennung eines Fehlers von dem mindestens einen Schutzgerät unmittelbar vor und/oder während des Fehlers erfasste zeitliche Verläufe der Messgrößen hinsichtlich des Vorliegens bestimmter Kriterien untersucht werden, wobei den einzelnen Kriterien und/oder Kombinationen von Kriterien mögliche Ursachen von Fehlern zugeordnet sind, ein oder mehrere Kriterien ermittelt werden, die von den untersuchten Verläufen der Messgrößen ganz oder teilweise erfüllt sind und abhängig von den ermittelten Kriterien und dem Grad ihrer Erfüllung durch die Verläufe eine Ursache des Fehlers ermittelt wird. Die Erfindung betrifft auch ein elektrisches Schutzgerät zum Ermitteln einer Ursache eines Fehlers in einem elektrischen Energieversorgungsnetz. Das erfindungsgemäße Verfahren und das erfindungsgemäße Schutzgerät finden beispielsweise Anwendung in einer Digitalen Unterstation (Digital Substation) eines Energieversorgungsnetzes.

Aus der WO 95/09463 A1 ist ein Verfahren bekannt, mit dem eine Unterscheidung zwischen vorübergehenden und permanenten metallischen Fehlern durchgeführt werden kann. Ähnliche Verfahren sind aus der WO 97/36185 A1 und der DE 44 330 406 C1 bekannt.

Zur Überwachung von Primärkomponenten, z.B. Leitungen, elektrischer Energieversorgungsnetze werden sogenannte Schutzgeräte eingesetzt, um unzulässige Betriebszustände der jeweils überwachten Primärkomponente, die beispielsweise durch Kurzschlüsse oder Erdkurzschlüsse hervorgerufen sein können, zu erkennen und automatisch abzuschalten. Hierzu nimmt das Schutzgerät üblicherweise an einer oder mehreren Messstellen in dem Energieversorgungsnetz Messgrößen auf, beispielsweise in Form von Strom- und/oder Spannungsmesswerten, die den Betriebszustand der Primärkomponente charakterisieren. Zur Ausführung seiner Schutzfunktion, wertet das Schutzgerät daraufhin die Messgrößen unter Ausführung eines sogenannten Schutzalgorithmus, also einer Berechnungs- und/oder logischen Verknüpfungsvorschrift zur Auswertung der aufgenomenen Messgrößen, aus und erzeugt in Abhängigkeit vom Ergebnis der Auswertung gegebenenfalls ein Fehlersignal, das einen mit dem Schutzgerät in Verbindung stehenden Leistungsschalter zum Öffnen seiner Schaltkontakte veranlasst, um den fehlerbehafteten Abschnitt vom übrigen Energieversorgungsnetz abzutrennen.

Ein Beispiel eines häufig zur Überwachung von Energieversorgungsnetzen eingesetzten Schutzalgorithmus arbeitet nach dem sogenannten Distanzschutzverfahren, bei dem aus Strom- und Spannungsmesswerten in einer komplexen Zahlenebene liegende Impedanzwerte berechnet werden und überprüft wird, ob die Impedanzwerte innerhalb eines - auch als Auslösepolygon bezeichneten - vorgegebenen Auslösebereiches liegen. Sofern die Impedanzwerte innerhalb dieses vorgegebenen Auslösebereiches liegen, stellt das Schutzgerät einen unzulässigen Betriebszustand an der von ihm überwachten Leitung des elektrischen Energieversorgungsnetzes fest und sendet ein Fehlersignal an einen oder mehrere die Leitung begrenzende Leistungsschalter, um die fehlerhafte Leitung vom restlichen Energieversorgungsnetz zu trennen. Die Höhe des Impedanzwertes gibt außerdem Aufschluss über die Lage des Fehlers auf der Leitung.

Die Verwendung elektrischer Schutzgeräte zur Überwachung von Energieversorgungsnetzen hinsichtlich möglicherweise auftretender Fehler ist allgemein bekannt. Entsprechende Schutzgeräte werden von der Anmelderin beispielsweise unter der Bezeichnung SIPROTEC vertrieben.

Bisher beschränkt sich die Erkennung eines Fehlers mittels eines Schutzgerätes auf das bloße Vorliegen des Fehlers; es bleibt daraufhin dem Betreiber des Energieversorgungsnetzes überlassen, die Ursache des Fehlers herauszufinden. Die eigentlichen Fehlerursachen sind dabei nämlich durchaus vielfältig, dazu zählen zum Beispiel Erdarbeiten im Umfeld von Kabeln, Bäume, die in Freileitung hineinwachsen, Tiere, die mit Leitungen in Kontakt kommen, Alterung von Isolierungen oder der Diebstahl von Kabeln und Freileitungen.

Freileitungen oder Kabel von Energieversorgungsnetzen in sehr dünn oder nicht besiedelten Gebieten sind - aufgrund des relativ hohen Wertes des verwendeten Leiter, z.B. Kupfer - nämlich häufig von Diebstahl der Leitungen betroffen. Um die Kabel oder Leitungen gefahrlos entfernen zu können, wird von den Dieben bewusst ein Kurzschluss hervorgerufen, z.B. indem mit einem Kran oder Bagger in die Leitung eingegriffen wird. Von den an den Leitungsenden installierten Schutzgeräten wird dieser Kurzschluss als Fehler erkannt, und die Leitung wird an beiden Seiten vom Netz getrennt. Der Kurzschluss wird von den Schutzgeräten zwar als Fehler angezeigt, es gibt jedoch keinen Hinweis auf seine Ursache, nämlich ob dieser Kurzschluss bewusst erzeugt wurde oder durch ein Naturereignis wie z.B. Blitzeinschlag, Wuchs von Pflanzen in die Leitung, verschmutzter Isolatoren oder einem technischen Defekt des Kabels hervorgerufen wurde.

Je nach Fehlerursache muss der Betreiber des Netzes unterschiedliche Maßnahmen veranlassen, um den Fehler und seine Auswirkungen zu beheben. Im Falle zufällig und/oder unabsichtlich hervorgerufener Fehler ist ein Wartungsteam mit entsprechender Ausrüstung an die Fehlerstelle zu entsenden, um den Fehler zu beheben. Im Falle eines zu Zwecken des Diebstahls bewusst herbeigeführten Fehlers sind die Polizei oder ein Sicherheitsdienst zu informieren. Da jedoch bisher kein Hinweis auf die Fehlerursache und damit z.B. auf einen möglicherweise bewusst hervorgerufenen Kurzschluss vorliegt, ist es oft nicht möglich, Sicherheitspersonal oder Polizei rechtzeitig zur Fehlerstelle zu schicken.

Bisher findet keine automatische Erkennung einer Fehlerursache statt. Die Ermittlung einer Fehlerursache kann meist erst im Nachhinein durch Inaugenscheinnahme der Fehlerstelle vor Ort ermittelt werden.

Es wäre deshalb wünschenswert, wenn das Schutzgerät dem Personal des Netzbetreibers beim Auslösen auch eine vermutliche Fehlerursache mitteilen würde.

Somit liegt der Erfindung die Aufgabe zugrunde, neben einer Erkennung eines Fehlers in einem Energieversorgungsnetz auch eine Ursache des Fehlers zu ermitteln.

Diese Aufgabe wird erfindungsgemäß durch ein Verfahren der eingangs angegebenen Art gelöst, bei dem zumindest einige der Kriterien dazu geeignet sind, absichtlich herbeigeführte Fehler zu erkennen, wobei als auf einen absichtlich herbeigeführten Fehler hindeutende Kriterien mehrere der folgenden Kriterien verwendet werden:

- die Erkennung eines permanent vorliegenden Fehlers;
- die Erkennung einer wiederholten automatischen Aus- und Einschaltung einer Phase einer Leitung innerhalb eines vorgegebenen Zeitraums;
- ein Fehlerwiderstand, der unterhalb eines vorgegebenen Schwellenwertes liegt; und
- sofern die Überprüfung ergibt, dass der Fehler absichtlich herbeigeführt worden ist, ein Alarmsignal erzeugt wird, das auf einen möglichen Leitungsdiebstahl hindeutet.

Bei dem erfindungsgemäßen Verfahren werden somit Verläufe der aufgenommenen Messgrößen, z.B. Ströme, Spannungen, Phasenwinkel, Frequenzen etc., mit bestimmten vorgegebenen Kriterien verglichen. Jedes Kriterium beschreibt hierbei eine oder mehrere Eigenschaften der jeweiligen Messgrößen (z.B. eine Schwellenwertüberschreitung, einen bestimmten Anteil an Oberschwingungen, ein plötzliches Ansteigen oder Absinken, bestimmte charakteristische Muster im Verlauf), die ganz oder teilweise erfüllt sind, wenn eine bestimmte Ursache eines Fehlers vorliegt. Durch Vergleich der Verläufe der Messgrößen mit den jeweiligen Kriterien kann - abhängig von der ganzen oder teilweisen Erfüllung eines oder mehrerer Kriterien - auf eine wahrscheinliche Fehlerursache geschlossen werden. Wenn nämlich eines oder mehrere Kriterien mit einem hinreichenden Erfüllungsgrad (d.h vollständig oder oberhalb eines Schwellenwertes) durch die betrachteten Verläufe der Messgrößen erfüllt sind, kann die diesem Kriterium oder dieser Kombination von Kriterien zugeordnete Ursache als wahrscheinlich für den Fehler angenommen werden. Auf diese Weise kann neben der bloßen Erkennung des Fehlers auch eine mögliche Fehlerursache ermittelt werden.

Erfindungsgemäß ist vorgesehen, dass zumindest einige der Kriterien dazu geeignet sind, absichtlich herbeigeführte Fehler zu erkennen, und sofern die Überprüfung ergibt, dass der Fehler absichtlich herbeigeführt worden ist, ein Alarmsignal erzeugt wird, das auf einen möglichen Leitungsdiebstahl hindeutet.

Absichtlich herbeigeführte Fehler deuten nämlich auf eine böswillige Manipulation des Energieversorgungsnetzes hin, beispielsweise auf einen Leitungsdiebstahl. Hierbei wird absichtlich ein Fehler auf einer Leitung erzeugt, beispielsweise indem mit einer Baggerschaufel in die Leitung eingegriffen wird. Der entstehende Kurzschluss veranlasst ein die Leitung überwachendes Schutzgerät zur Abschaltung der Leitung. Wenn diese stromlos ist, kann die Leitung verhältnismäßig gefahrlos abgetrennt und entwendet werden. Daher ist die Erkennung eines absichtlich herbeigeführten Fehlers besonders wichtig, um zeitnah entsprechende Gegenmaßnahmen, z.B. das Alarmieren der Polizei, treffen zu können.

Konkret ist in diesem Zusammenhang vorgesehen, dass als auf einen absichtlich herbeigeführten Fehler hindeutende Kriterien eines oder mehrere der folgenden Kriterien verwendet werden:

- die Erkennung eines permanent vorliegenden Fehlers;
- die Erkennung einer wiederholten automatischen Aus- und Einschaltung einer Phase einer Leitung innerhalb eines vorgegebenen Zeitraums;
- ein Fehlerwiderstand, der unterhalb eines vorgegebenen Schwellenwertes liegt.

Diese Kriterien sind nämlich einzeln, insbesondere aber auch in Kombination dazu geeignet, einen absichtlich herbeigeführten Fehler von einem zufällig oder unabsichtlich eintretenden Fehler zu unterscheiden. Beispielsweise ergeben statistische Analysen von Fehlerfällen, dass die Mehrzahl der auftretenden Fehler temporäre Fehler sind, die z.B. durch in eine Freileitung hineinwachsende und bei Berührung mit der Leitung abbrennende Pflanzenteile hervorgerufen werden. Beim Leitungsdiebstahl hingegen muss vor der Entfernung der Leitung ein permanent vorliegender Fehler herbeigeführt werden. Somit weist das Vorliegen eines - statistisch gesehen seltenen - permanenten Fehlers auf die Möglichkeit eines absichtlich herbeigeführten Fehlers hin. Üblicherweise führen Schutzgeräte nach der erstmaligen Abschaltung einer Leitung eines Energieversorgungsnetzes eine oder mehrere automatische Wiedereinschaltungen durch, um bei temporären Fehlern die Ausfallzeit der Leitung möglichst gering zu halten. Wird beim Einschalten festgestellt, dass der Fehler noch vorliegt, wird der Einschaltvorgang unterbrochen bzw. die Leitung erneut abgeschaltet. Wird nun festgestellt, dass die Leitung zwar mehrfach erfolgreich wieder eingeschaltet worden ist (ein permanenter Fehler liegt somit nicht vor), jedoch innerhalb kurzer Zeit wegen eines weiteren Fehlers erneut wieder abgeschaltet werden muss, deutet dies auf eine absichtliche Manipulation hin. Schließlich deutet auch ein sehr geringer Fehlerwiderstand auf einen absichtlich herbeigeführten Fehler hin, da hierbei mit metallischen Gegenständen (z.B. Baggerschaufel) ein Kurzschluss herbeigeführt wird, während ein durch andere Ereignisse hervorgerufener Fehler meist mit einem höheren Fehlerwiderstand verbunden ist. Die Bestimmung des Fehlerwiderstandes kann beispielsweise mit einem Verfahren, wie es in der EP 2937704 A1 beschrieben ist, durchgeführt werden.

Eine vorteilhafte Ausführungsform des erfindungsgemäßen Verfahrens sieht vor, dass von dem mindestens einen Schutzgerät ein Signal abgegeben wird, das die ermittelte Ursache angibt. Bei dieser Ausführungsform kann der Betreiber des Energieversorgungsnetzes sehr einfach, nämlich durch Übermittlung des die ermittelte Ursache angebenden Signals, über die Fehlerursache informiert werden, um zeitnah entsprechende Gegenmaßnahmen veranlassen zu können. Das Signal kann hierbei entweder als optisches oder akustisches Signal ausgegeben oder in Form eines Datentelegramms mit entsprechendem Inhalt übermittelt werden. Beispielsweise kann auf diese Weise eine Übermittlung der Information über die ermittelte Ursache an eine Netzleitstelle erfolgen.

Gemäß einer weiteren vorteilhaften Ausführungsform kann vorgesehen sein, dass als auf einen absichtlich herbeigeführten Fehler hindeutendes Kriterium eine auf einer fehlerbehafteten Leitung erkannte Trennstelle verwendet wird.

Die Erkennung einer (dauerhaft vorhandenen) Trennstelle auf der Leitung deutet nämlich darauf hin, dass bereits eine Auftrennung der Leitung stattgefunden hat. Bei einem üblichen Fehler findet meist keine Auftrennung der Leitung statt, so dass auch dieses Kriterium auf einen absichtlich herbeigeführten Fehler hinweisen kann.

Konkret kann in diesem Zusammenhang vorgesehen sein, dass zur Überprüfung, ob eine Trennstelle vorliegt, während einer temporären Wiedereinschaltung der fehlerbehafteten Leitung sich auf der Leitung ausbreitende Wanderwellen des Stroms und/oder der Spannung untersucht werden, wobei die Trennstelle an derjenigen Stelle der Leitung erkannt wird, an der eine den Stromverlauf entlang der fehlerbehafteten Leitung angebende Zielfunktion ein Minimum aufweist.

Mittels der Wanderwellenmethode lässt sich nämlich besonders gut eine vorliegende Trennstelle ermitteln, da die sich ausbreitenden Wellen eines Strom- bzw. Spannungsimpulses an der Trennstelle reflektiert werden und die zurückgeworfenen Anteile als Reflektionen gemessen werden können. Aus ihnen lässt sich auf das Vorhandensein einer Trennstelle und ihre Entfernung von der Messstelle schließen.

Außerdem kann in diesem Zusammenhang gemäß einer vorteilhaften Ausführungsform des erfindungsgemäßen Verfahrens vorgesehen sein, dass nach dem Eintritt des Fehlers eine Fehlerortung durchgeführt wird und der ermittelte Fehlerort mit dem Ort der ermittelten Trennstelle verglichen wird, und der Erfüllungsgrad des Kriteriums hinsichtlich einer vorliegenden Trennstelle in Abhängigkeit vom Abstand zwischen dem Fehlerort und der Lage der Trennstelle ermittelt wird.

Liegt nämlich die (dauerhafte) Trennstelle an derjenigen Stelle, wo auch der Fehler aufgetreten ist, so deutet auch dies darauf hin, dass der Fehler absichtlich herbeigeführt worden ist, um die Leitung nach ihrer Abschaltung auftrennen zu können.

Gemäß einer weiteren vorteilhaften Ausführungsform des erfindungsgemäßen Verfahrens kann in Zusammenhang mit der Erkennung absichtlich herbeigeführter Fehler vorgesehen sein, dass aus dem jeweiligen Erfüllungsgrad der einzelnen auf einen absichtlich herbeigeführten Fehler hinweisenden Kriterien jeweils Wahrscheinlichkeitswerte ermittelt werden, die die Wahrscheinlichkeit angeben, dass die Erfüllung des jeweiligen Kriteriums tatsächlich einen absichtlich herbeigeführten Fehler bedeutet, durch Verknüpfung der einzelnen Wahrscheinlichkeitswerte ein Gesamt-Wahrscheinlichkeitswert ermittelt wird, der Gesamt-Wahrscheinlichkeitswert mit einem Wahrscheinlichkeits-Schwellenwert verglichen wird, und das Alarmsignal erzeugt wird, wenn der Gesamt-Wahrscheinlichkeitswert den Wahrscheinlichkeits-Schwellenwert übersteigt.

Auf diese Weise lässt sich besonders gut aus einer Kombination einzelner Kriterien sowie dem Grad ihrer Erfüllung auf das Vorliegen eines absichtlich herbeigeführten Fehlers schließen. Hierbei trägt nämlich jedes einzelne Kriterium zur Bildung eines Gesamt-Wahrscheinlichkeitswertes bei, der herangezogen wird, um bestimmen zu können, ob ein absichtlich herbeigeführter Fehler wahrscheinlich vorliegt oder nicht.

Eine weitere vorteilhafte Ausführungsform des erfindungsgemäßen Verfahrens sieht in Zusammenhang mit der Erkennung absichtlich herbeigeführter Fehler vor, dass das Schutzgerät einen Fehler in dem Energieversorgungsnetz mittels einer Distanzschutzfunktion erkennt, und eine Information über die mit der Distanzschutzfunktion erkannte Entfernung des Fehlers von der dem Schutzgerät zugeordneten Messstelle dem Alarmsignal beigefügt wird.

Auf diese Weise kann der Polizei oder einem Einsatzdienst sehr einfach ein Hinweis gegeben werden, wo ein Leitungsdiebstahl aktuell stattfinden könnte. Da im Zusammenhang mit einem Distanzschutzverfahren die Fehlerstelle üblicherweise mit bestimmt wird, kann diese Information ohne Weiteres mit dem Alarmsignal ausgegeben werden.

Alternativ dazu kann gemäß einer vorteilhaften Ausführungsform des erfindungsgemäßen Verfahrens auch vorgesehen sein, dass nach dem Eintritt des Fehlers von dem Schutzgerät eine Fehlerortung durchgeführt wird, und eine Information über den ermittelten Fehlerort dem Alarmsignal beigefügt wird.

Diese Ausführungsform ermöglicht es - unabhängig vom zur Fehlererkennung eingesetzten Schutzverfahren - dem Alarmsignal eine Information über den Ort beizufügen, an dem der Fehler aufgetreten ist. Eine Fehlerortung kann hierbei mit einem beliebigen Fehlerortungsverfahren, z.B. einer einseitigen oder zweiseitigen impedanzbasierten Fehlerortung, durchgeführt werden. Bekannte Fehlerortungsverfahren können beispielsweise der US-Patentschrift US 4996624 A oder der US-Patentschrift US 5,929,642 entnommen werden.

Die oben genannte Aufgabe wird auch durch ein Schutzgerät zum Ermitteln einer Ursache eines Fehlers in einem elektrischen Energieversorgungsnetz, wobei das Schutzgerät eine Recheneinrichtung aufweist, die dazu eingerichtet ist, unter Verwendung von an mindestens einer Messstelle des Energieversorgungsnetzes erfasster elektrischer Messgrößen eine Untersuchung hinsichtlich des Vorliegens eines Fehlers in dem elektrischen Energieversorgungsnetz durchzuführen und im Falle eines erkannten Fehlers ein Fehlersignal zu erzeugen, wobei die Recheneinrichtung dazu eingerichtet ist, nach der Erkennung eines Fehlers unmittelbar vor und/oder während des Fehlers erfasste zeitliche Verläufe der Messgrößen hinsichtlich des Vorliegens bestimmter Kriterien zu untersuchen, wobei den einzelnen Kriterien und/oder Kombinationen von Kriterien mögliche Ursachen von Fehlern zugeordnet sind, ein oder mehrere Kriterien zu ermitteln, die von den untersuchten Verläufen der Messgrößen ganz oder teilweise erfüllt sind und abhängig von den ermittelten Kriterien und dem Grad ihrer Erfüllung durch die Verläufe eine Ursache des Fehlers zu ermitteln.

Erfindungsgemäß ist vorgesehen, dass die Recheneinrichtung dazu eingerichtet ist, nach der Erkennung eines Fehlers unmittelbar vor und/oder während des Fehlers erfasste zeitliche Verläufe der Messgrößen hinsichtlich des Vorliegens bestimmter Kriterien zu untersuchen, wobei den einzelnen Kriterien und/oder Kombinationen von Kriterien mögliche Ursachen von Fehlern zugeordnet sind, ein oder mehrere Kriterien zu ermitteln, die von den untersuchten Verläufen der Messgrößen ganz oder teilweise erfüllt sind, und abhängig von den ermittelten Kriterien und dem Grad ihrer Erfüllung durch die Verläufe eine Ursache des Fehlers zu ermitteln.

Hinsichtlich des erfindungsgemäßen Schutzgerätes gelten alle zu dem erfindungsgemäßen Verfahren voranstehend und nachfolgend gemachten Ausführungen und umgekehrt in entsprechender Weise, insbesondere ist das erfindungsgemäße Schutzgerät zur Durchführung des erfindungsgemäßen Verfahrens in jeder beliebigen Ausführungsform oder einer Kombination beliebiger Ausführungsformen eingerichtet. Auch hinsichtlich der Vorteile des erfindungsgemäßen Schutzgerätes wird auf die zu dem erfindungsgemäßen Verfahren beschriebenen Vorteile verwiesen.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen Verfahrens und des erfindungsgemäßen Schutzgerätes in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Hierzu zeigen

Figur 1    eine schematische Ansicht einer Leitung in einem elektrischen Energieversorgungsnetz, die von einem Schutzgerät überwacht wird;

Figur 2    eine schematische Ansicht einer Leitung in einem elektrischen Energieversorgungsnetz, die von zwei Schutzgeräten überwacht wird;

Figur 3    eine schematische Ansicht eines Schutzgerätes zur Erläuterung einer zur Erkennung der Ursache eines Fehlers durchgeführten Mustererkennung;

Figur 4    ein beispielhaftes Ablaufschema zur Erläuterung der Erkennung eines absichtlich herbeigeführten Fehlers;

Figur 5    ein beispielhaftes Diagramm zur Erläuterung der Bildung eines Wahrscheinlichkeitswertes;

Figur 6    ein beispielhaftes Diagramm mit Messwerten von Strom und Spannung zur Ermittlung der Lage einer Trennstelle auf einer Leitung;

Figur 7    ein beispielhaftes Diagramm mit aus Messwerten von Strom und Spannung gebildeten modalen Komponenten;

Figur 8    ein beispielhaftes Diagramm mit modalen Komponenten von Strom und Spannung im Frequenzbereich; und

Figur 9    ein beispielhaftes Diagramm mit der Darstellung des Verlaufs einer Zielfunktion zur Erläuterung der Ermittlung der Lage einer Trennstelle auf einer Leitung.

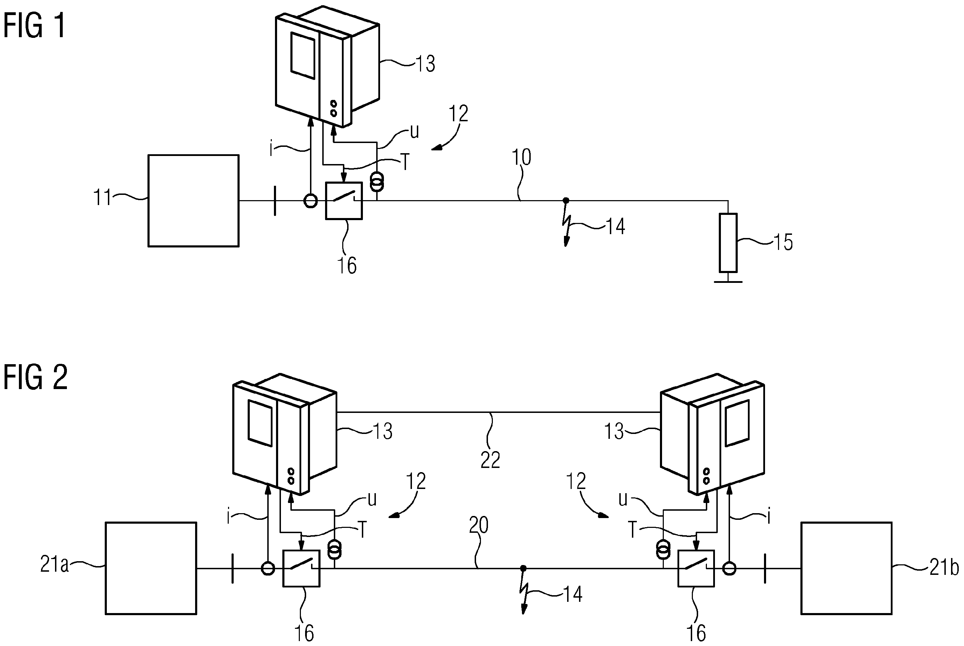

Figur 1 zeigt in schematischer Darstellung eine Leitung 10 eines im Übrigen nicht weiter dargestellten elektrischen Energieversorgungsnetzes 11. Bei der Leitung 10 handelt es sich um eine einseitig gespeiste Leitung 10, die an ihrem dem Energieversorgungsnetz 11 abgewandten Seite mit einer nur schematisch angedeuteten Last 15 verbunden ist.

Die Leitung 10 wird an einer Messstelle 12 von einem Schutzgerät 13 hinsichtlich des Vorliegens etwaiger Fehler 14 überwacht. Dazu werden an der Messstelle 12 mittels lediglich schematisch angedeuteter Messwandler Messgrößen in Form von Strom i und Spannung u aufgenommen und dem Schutzgerät 13 zugeführt. Eine in Figur 1 nicht gezeigte Recheneinrichtung, z.B. ein eine Gerätesoftware ausführender Mikroprozessor, wertet die erfassten Messgrößen unter Anwendung sogenannter Schutzalgorithmen (z.B. Distanzschutz, Überstromschutz) aus und gibt ein Fehlersignal T ab, wenn ein auf der Leitung liegender Fehler 14 erkannt worden ist, um einen die Leitung begrenzenden Leistungsschalter 16 zum Öffnen seiner Schaltkontakte zu veranlassen und damit die fehlerbehaftete Leitung 10 vom übrigen Energieversorgungsnetz 11 abzutrennen.

Figur 2 zeigt in schematischer Darstellung ein weiteres Ausführungsbeispiel einer Leitung 20 einen im Übrigen nicht weiter gezeigten elektrischen Energieversorgungsnetzes 21a, 21b. Der Figur 1 entsprechende Komponenten sind in Figur 2 mit entsprechenden Bezugszeichen gekennzeichnet.

Bei dem Ausführungsbeispiel gemäß Figur 2 ist die Leitung 20 von beiden Seiten gespeist und wird mit zwei an Messstellen 12 an beiden Enden angeordneten Schutzgeräten 13 überwacht. Die Schutzgeräte 13 können optional mittels einer Kommunikationsverbindung 22 zum Datenaustausch miteinander verbunden sein.

Auch bei dem Ausführungsbeispiel der Figur 2 überwachen die Schutzgeräte 13 anhand von an den Messstellen 12 aufgenommenen Messgrößen (z.B. Strom, Spannung) unter Verwendung geeigneter Schutzalgorithmen (z.B. Differentialschutz) die Leitung 20 hinsichtlich etwaiger Fehler 14 und geben im Fehlerfall Fehlersignale an die Leistungsschalter 16 ab, um diese zum Abtrennen der Leitung 20 zu veranlassen.

Diese hinsichtlich Figuren 1 und 2 beschriebene Funktionsweise von Schutzgeräten ist hinlänglich bekannt.

Obwohl in Figuren 1 und 2 der Übersichtlichkeit halber einphasige Energieversorgungsnetze gezeigt sind, kann es sich bei den Energieversorgungsnetzen auch um mehrphasige, insbesondere dreiphasige, Netze handeln.

Üblicherweise wird im Fehlerfall über eine an eine Netzleitstelle des Energieversorgungsnetzes gesendete Nachricht (z.B. ein über ein in Figuren 1 und 2 nicht gezeigtes Kommunikationsnetz gesendetes Datentelegramm) der Betreiber des Energieversorgungsnetzes über den vorliegenden Fehler informiert, um eine zeitnahe Fehlerbehebung zu veranlassen. Eine mögliche Ursache des Fehlers wird hingegen in bisherigen Systemen nicht ermittelt, so dass der Netzbetreiber darauf angewiesen ist, durch Inaugenscheinnahme der Fehlerstelle die Ursache zu ermitteln.

Daher werden im Folgenden Ausführungsbeispiele von Schutzgeräten vorgestellt, die neben der bloßen Erkennung des Vorliegens eines Fehlers auch eine Ermittlung der Ursache durchführen. Hierzu werden in dem Schutzgerät 13 gespeicherte Verläufe der Messgrößen, die vor und/oder während des Fehlers aufgenommen worden sind, mit mehreren vorgegebenen Kriterien verglichen. Jedes Kriterium und/oder eine Kombination bestimmter Kriterien weist auf eine bestimmte Fehlerursache hin. Somit ist jedem Kriterium und/oder jeder Kombination von Kriterien eine Fehlerursache zugeordnet. Bei Erkennung der vollständigen oder teilweisen Erfüllung eines oder mehrerer Kriterien kann das Schutzgerät anhand der den Kriterien zugeordneten Ursachen diejenige Ursache ermitteln, auf die die erfüllten Kriterien am meisten hinweisen.

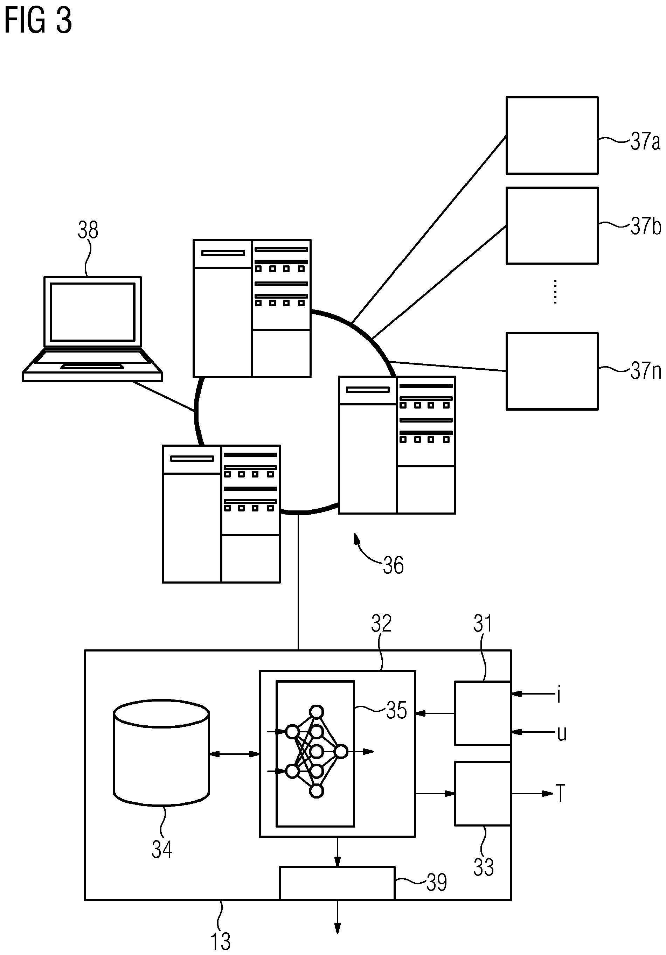

Ein erstes Ausführungsbeispiel eines solchen Schutzgerätes wird im Zusammenhang mit Figur 3 beschrieben. Den Figuren 1 und 2 entsprechende Komponenten sind wiederum mit entsprechenden Bezugszeichen gekennzeichnet: Figur 3 zeigt in schematischer Ansicht ein Schutzgerät 13, das dazu eingerichtet ist, eine Ursache eines Fehlers in einem Energieversorgungsnetz zu ermitteln. Dem Schutzgerät werden in bekannter Weise über einen oder mehrere Messeingänge 31 Messgrößen wie Strom i, Spannung u zugeführt (vgl. Figuren 1 und 2). Mittels einer Recheneinrichtung 32 führt das Schutzgerät 13 unter Verwendung eines Schutzalgorithmus eine Fehlererkennung durch und gibt über einen Kommandoausgang 33 im Fehlerfall das Fehlersignal T aus. Als Recheneinrichtung 32 soll in diesem Zusammenhang ein Rechenbaustein inklusive einer geeigneten Programmierung angesehen werden, beispielsweise ein mittels einer Software programmierter Prozessor oder ein Rechenbaustein mit hardwarebasierter Programmierung (z.B. ASIC, FPGA).

Neben der Fehlererkennung ist das Schutzgerät 13 mit einem Algorithmus zur Mustererkennung ausgerüstet. Dazu werden die aufgenommenen Messgrößen zumindest temporär in einem Messwertspeicher 34 des Schutzgerätes 13 abgespeichert. Die gespeicherten Verläufe der Messgrößen werden im Falle eines Fehlers zur Ermittlung der Fehlerursache unter Verwendung der Mustererkennung genutzt. Hierzu wird im Fehlerfall im Schutzgerät 13 aus den gespeicherten Verläufen der Messgrößen zunächst eine Matrix (z.B. Strom und Spannung nach Betrag und Phase) aufgebaut. Dazu wird der gespeicherte Verlauf an verschiedenen Zeitpunkten abgetastet. Die Abtastintervalle können äquidistant oder progressiv ausgeführt werden (progressiv: kleinere Abtastintervalle in zeitlicher Nähe des Fehlers und größere Intervalle in der weiter zurückliegenden Vergangenheit). Die entstehende Matrix kann beispielsweise die nach-

folgend dargestellte Form annehmen:

$$\begin{pmatrix} I_{1,t} & I_{2,t} & I_{3,t} & I_{E,t} & \varphi_{1,t} & \varphi_{2,t} & \varphi_{3,t} & \varphi_{E,t} & U_{1,t} & U_{2,t} & U_{2,t} & \theta_{1,t} & \theta_{2,t} & \theta_{3,t} \\ I_{1,t-1} & I_{2,t-1} & I_{3,t-1} & I_{E,t-1} & \varphi_{1,t-1} & \varphi_{1,t-1} & \varphi_{1,t-1} & \varphi_{E,t-1} & U_{1,t-1} & U_{2,t-1} & U_{2,t-1} & \theta_{1,t-1} & \theta_{2,t-1} & \theta_{3,t-1} \\ \vdots & \ddots & & & & & & & & & & & & \\ I_{1,t-T} & I_{1,t-T} & I_{3,t-T} & I_{E,t-T} & \varphi_{1,t-T} & \varphi_{1,t-T} & \varphi_{1,t-T} & \varphi_{E,t-T} & U_{1,t-T} & U_{2,t-T} & U_{2,t-T} & \theta_{1,t-T} & \theta_{2,t-T} & \theta_{3,t-T} \end{pmatrix}$$

mit

I Strombetrag;
φ Phasenwinkel des Stroms;
U Betrag der Spannung;
Θ Phasenwinkel der Spannung;
t Zeitpunkt des Fehlers;
T Anzahl der Abtastintervalle.

Die Aufgabe der Mustererkennung liegt nun in der Zuordnung der Matrix zu einem eine Fehlerursache angebenden Kriterium k:

$$\begin{pmatrix} I_{1,t} & I_{2,t} & I_{3,t} & I_{E,t} & \varphi_{1,t} & \varphi_{2,t} & \varphi_{3,t} & \varphi_{E,t} & U_{1,t} & U_{2,t} & U_{2,t} & \theta_{1,t} & \theta_{2,t} & \theta_{3,t} \\ I_{1,t-1} & I_{2,t-1} & I_{3,t-1} & I_{E,t-1} & \varphi_{1,t-1} & \varphi_{1,t-1} & \varphi_{1,t-1} & \varphi_{E,t-1} & U_{1,t-1} & U_{2,t-1} & U_{2,t-1} & \theta_{1,t-1} & \theta_{2,t-1} & \theta_{3,t-1} \\ \vdots & \ddots & & & & & & & & & & & & \\ I_{1,t-T} & I_{1,t-T} & I_{3,t-T} & I_{E,t-T} & \varphi_{1,t-T} & \varphi_{1,t-T} & \varphi_{1,t-T} & \varphi_{E,t-T} & U_{1,t-T} & U_{2,t-T} & U_{2,t-T} & \theta_{1,t-T} & \theta_{2,t-T} & \theta_{3,t-T} \end{pmatrix}$$

$$\to k \in \{1..K | K \in N\}$$

mit

k Kriterium;
K Anzahl der Kriterien.

Die dargestellte Matrix soll lediglich eine beispielhafte Ausführungsform einer zur Mustererkennung geeigneten Matrix darstellen. In entsprechender Weise können Matrizen mit eine größeren oder kleineren Anzahl von Parametern für die Mustererkennung herangezogen werden.

Zur Durchführung einer Mustererkennung, d.h. der Zuordnung der in der Matrix dargestellten Verläufe der Messgrößen zu einem oder mehreren bestimmten Kriterien, ist in der Recheneinrichtung 32 des Schutzgerätes ein künstliches neuronales Netz 35 (KNN) implementiert. Zur Mustererkennung mittels KNN existiert eine Reihe von Verfahren, die zum Einsatz gelangen können, z.B. Multilayer-Perzeptronen-Modelle oder Support Vector Machines.

Um eine Mustererkennung durchführen zu können, muss das KNN entsprechend angelernt sein. Hierzu werden in einer Trainingsphase dem neuronalen Netz zunächst bekannte Musterpaare präsentiert, in diesem Falle also Matrizen mit Messgrößen (z.B. entsprechend der obigen Darstellung) und das dazugehörige die Ursache des Fehlers angebende Kriterium. Dabei "lernt" das KNN die inneren Zusammenhänge zwischen den Musterpaaren und kann sie danach auf neue Eingangsdaten in Form von aus Verläufen der Messgrößen gebildeten Matrizen anwenden.

Da das Anlernen eines neuronalen Netzes ein rechenintensiver Vorgang ist und im Betrieb eingesetzte Schutzgeräte im Allgemeinen nur sehr selten eine Fehlersituation erleben, sollte das Anlernen des neuronalen Netzes außerhalb des Schutzgerätes in einem externen Datenverarbeitungssystem 36 erfolgen.

Dabei kann es sich z.B. um ein zentrales cloudbasiertes Datenverarbeitungssystem handeln, bei dem eine oder mehrere Datenverarbeitungseinrichtungen mit geeigneter Programmierung entsprechende Verfahren zum Anlernen eines neuronalen Netzes durchführen. In dem externen Datenverarbeitungssystem sind Musterpaare (Matrizen und die dazu gehörigen Fehlerursachen) von einer Vielzahl von Schutzgeräten 37a-n, ergänzt ggf. durch aus Simulationen gewonnene Fehlerinformationen, abgespeichert. Diese Musterpaare bilden die Trainingsdaten für das neuronale Netz. Weiterhin enthält das externe Datenverarbeitungssystem 36 ein neuronales Netz, das strukturgleich zu dem neuronalen Netz ist, das in dem Schutzgerät 13 implementiert ist. In dem externen Datenverarbeitungssystem 36 wird zunächst das dort vorliegende neuronale Netz mit Hilfe der gesammelten Fehlerinformationen (Musterpaare) trainiert. Nach Abschluss des Trainings liegt eine Parametrierung des KNN vor, die an das in dem Schutzgerät 13 implementierte KNN übermittelt und dort eingestellt werden kann.

Die Trainingsdaten können z.B. aus gesammelten Störfalldaten von Herstellern oder Betreibern von Schutzgeräten für Energieversorgungsnetze stammen. Von diesen können sie dem externen Datenverarbeitungssystem, z.B. durch einen Upload, zur Verfügung gestellt werden. Dazu kann vorgesehen sein, dass das externe Datenverarbeitungssystem über einen browserbasierten Zugang verfügt, der ein Upload der Störfalldaten von einem Computer 38 eines Benutzers erlaubt. Nach erfolgreichem Upload weist der Bediener dem Störschrieb ein Kriterium eines Fehlers und damit eine Fehlerursache aus einer Sammlung von vordefinierten Kriterien zu oder erstellt ein neues Kriterium, falls das gewünschte Kriterium noch nicht existiert. Alternativ könnte auch eine Upload-Funktion in heute schon existierende Programme zur Analyse von sogenannten Störschrieben (gespeicherte Verläufe von Messgrößen für einzelne Fehlerfälle) integriert werden.

Nach dem Laden der Störfalldaten werden diese zunächst mit dem auf dem externen Datenverarbeitungssystem implementierten neuronalen Netz klassifiziert. Falls das Ergebnis des neuronalen Netzes dem Kriterium entspricht, das auch der Bediener ausgewählt hat, werden die Störinformation und das Kriterium zu einem gültigen Musterpaar. Falls das auf dem externen Datenverarbeitungssystem implementierte neuronale Netz hingegen zu einem anderen Kriterium (und damit einer anderen Ursache) kommt, wird zunächst der Administrator des externen Datenverarbeitungssystems informiert. Dieser setzt sich mit dem Bediener, der die fraglichen Störfalldaten ins System geladen hat, in Kontakt und klärt mit ihm, ob es sich um eine Fehleingabe seitens des Bedieners oder um eine Fehleinschätzung des neuronalen Netzes handelt. Im letzteren Fall werden Störfalldaten und das richtige zugehörige Kriterium direkt zu den Trainingsdaten zugefügt und das neuronale Netz neu trainiert. Im ersten Fall wird die Fehleingabe korrigiert und die Störfalldaten mit dem Kriterium ebenfalls zu den Trainingsdaten hinzugefügt; ein erneutes Training muss in diesem Fall nicht mehr erfolgen.

Nachdem das auf dem externen Datenverarbeitungssystem implementierte neuronale Netz angelernt ist und die Erkennung des richtigen Kriteriums mit einer ausreichend hohen Güte vornimmt, werden die Parameter des neuronalen Netzes an das Schutzgerät übermittelt. Dieser Parametersatz kann von der Firmware des Schutzgerätes ausgelesen werden, die damit das auf dem Schutzgerät implementierte neuronale Netz parametriert. Dies geschieht entweder beim Herstellen des Schutzgerätes oder bei einem Firmware-Update, wenn sich das Schutzgerät bereits im Betrieb befindet.

Mit dem auf diese Weise angelernten neuronalen Netz 35 kann das Schutzgerät 13 ohne die Notwendigkeit eines weiteren Datenaustauschs mit dem externen Datenverarbeitungssystem 36 eine Ermittlung der Ursache eines Fehlers vornehmen, da das neuronale Netz 35 anhand der charakteristischen Muster auf ein oder mehrere Kriterien schließt, denen die entsprechende Ursache zugeordnet ist.

Eine Information über die Ursache kann von dem Schutzgerät 13 über eine Kommunikationsschnittstelle 39 ausgegeben und lokal am Gerät zur Anzeige gebracht und/oder an den Netzbetreiber übertragen werden.

Vorteilhaft an dem beschriebenen Verfahren ist insbesondere auch, dass hiermit eine Reduktion von Aufwand und Kosten für die Fehlerbehebung verbunden ist. Bei Kenntnis der vermutlichen Fehlerursache kann der Netzbetreiber nämlich schneller geeignete Gegenmaßnahmen organisieren. Er muss nicht warten, bis die Wartungsmannschaft vor Ort ist und die Fehlerursache identifizieren kann. Damit reduziert sich der Aufwand für die Behebung der Fehler.

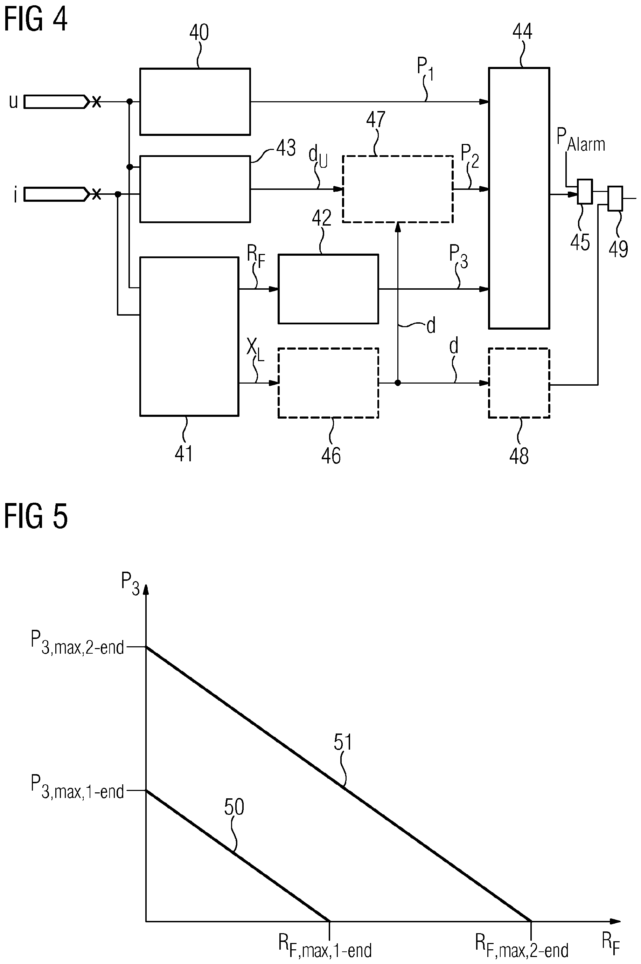

Ein weiteres Ausführungsbeispiel wird nachfolgend anhand der Figuren 4 bis 9 beschrieben. Die beschriebenen Ausführungsbeispiele können natürlich auch miteinander kombiniert werden.

Bei dem Ausführungsbeispiel gemäß der Figuren 4 bis 9 steht die Erkennung im Vordergrund, ob der Fehler absichtlich hervorgerufen worden ist und somit als Fehlerursache eine Manipulation an Teilen des Energieversorgungsnetzes vorliegt, oder ob es sich um eine unabsichtlichen oder zufälligen Fehler handelt.

Hierbei wird das Schutzgerät 13 derart weitergebildet, dass durch Auswertung der aufgenommenen Verläufe von Messgrößen (z.B. Ströme, Spannungen) anhand bestimmter Kriterien (z.B. Ergebnisse einer Schutzfunktion oder einer Fehlerortung) ein Signal gebildet wird, welches auf einen möglicherweise bewusst hervorgerufenen Kurzschluss hinweist und dem Netzbetreiber die Möglichkeit bietet, schnellstmöglich Sicherheitspersonal oder Polizei an den Ort des möglichen Leitungsdiebstahls zu schicken.

Die Meldung, dass ein möglicherweise durch Diebe bewusst erzeugter Kurzschluss vorliegt, wird beispielhaft durch verschiedene Kriterien und/oder deren Kombination erzeugt. Beispielsweise kann eine Erkennung stattfinden, ob ein Fehler permanent vorliegt und/oder ob eine wiederholte automatische Aus- und Einschaltung einer Phase einer Leitung innerhalb eines vorgegebenen Zeitraums stattfindet. Außerdem kann ein Fehlerwiderstand daraufhin untersucht werden, ob er unterhalb eines vorgegebenen Schwellenwertes liegt. Schließlich kann auch geprüft werden, ob auf einer fehlerbehafteten Leitung eine dauerhafte Trennstelle erkannt wird.

Eine Erkennung eines permanenten Fehlers sowie wiederholter Aus- und Einschaltvorgänge kann z.B. über eine Analyse der gemessenen Spannung während der sogenannten einpoligen Pause stattfinden. Dieses Kriterium funktioniert bei leitungsseitig angeschlossenen Spannungswandlern und bei einer einpoligen Auslösung. Während der spannungslosen Pause kann dann geprüft werden, ob trotz der Abschaltung eine Lichtbogenspannung gemessen werden kann.

Eine Bestimmung des Fehlerwiderstandes kann z.B. mit Hilfe einer im Schutzgerät vorgesehenen Fehlerortungsfunktion durchgeführt werden. Möglich ist die Bestimmung des Fehlerwiderstandes insbesondere bei Verwendung einer Fehlerortungsfunktion, die nach der sogenannten Reaktanzmethode arbeitet. Eine solche Fehlerortungsfunktion ist beispielsweise in der EP 2937704 A1 beschrieben. Mittels des Fehlerorters kann z.B. auch erkannt werden, ob ein Fehler in bestimmten, als risikobehaftet angesehenen Leitungsabschnitten (z.B. wegen fehlender Besiedelung etc.) aufgetreten ist.

Schließlich kann die Bestimmung der Stelle, an der die Leitung aufgetrennt wurde (Trennstelle) durch eine temporäre Wiedereinschaltung der Leitung erfolgen. Dazu ist der aufgrund des Fehlers geöffnete Leistungsschalter wieder zu schließen und mit Hilfe der entstehenden Einschwingvorgänge die Trennstelle zu bestimmen. Zur rechnerischen Lösung kann vorteilhaft die sogenannte Telegraphengleichung herangezogen werden, mit der sich elektrische Ausbreitungsvorgänge auf Leitungen beschreiben lassen.

Bei vollständiger oder teilweiser Erfüllung der Kriterien für sich oder einer Kombination der Kriterien kann von dem Schutzgerät 13 ein Alarmsignal erzeugt werden, das auf einen absichtlich herbeigeführten Fehler hindeutet. Dies kann z.B. dazu verwendet werden, um einen Sicherheitsdienst oder die Polizei zur Fehlerstelle zu entsenden.

Jedes dieser Entscheidungskriterien liefert als Ergebnis einen Wahrscheinlichkeitswert, dessen Wert üblicherweise zwischen 0...1 liegt. Bei Kombination werden die Wahrscheinlichkeitswerte dieser Kriterien miteinander zu einem Gesamt-Wahrscheinlichkeitswert verknüpft, z.B. aufsummiert. Bei Überschreitung eines festzulegenden Wahrscheinlichkeits-Schwellenwertes durch den Gesamt-Wahrscheinlichkeitswert wird das Alarmsignal abgegeben.

In Figur 4 ist schematisch ein Ablaufdiagramm gezeigt, in dem eine Kombination der beschriebenen Kriterien zur möglichst sicheren Erkennung eines absichtlich herbeigeführten Fehlers dargestellt ist.

Zunächst werden von der Recheneinrichtung des Schutzgerätes 13 Verläufe von Messgrößen untersucht (z.B. Leiter-Erde Spannungen $U_{L1E}$, $U_{L2E}$, $U_{L3E}$; Phasenströme $i_{L1}$, $i_{L2}$, $i_{L3}$), ob sie ein oder mehrere Kriterien erfüllen.

Gemäß einem ersten Kriterium findet eine Prüfung der Lichtbogenspannung in der spannungslosen Pause statt (Block 40). Kommt es auf einer Freileitung zu einem Kurzschluss, wird nach der Abschaltung der betroffenen Phase(n) in der Regel eine automatische Wiedereinschaltung durchgeführt. Dabei schaltet ein Schutzgerät die betroffenen Phase(n) des Leistungsschalters aus und nach einer kurzen Zeit wieder automatisch ein. Bei einem temporären Fehler (z.B. ein Ast fällt auf die Leitung und verbrennt) kann die automatische Wiedereinschaltung erfolgreich sein, während bei einem permanenten Fehler (z.B. durch einen metallischen Kurzschluss) die automatische Wiedereinschaltung erfolglos ist.

Im Folgenden wird nur auf eine einpolige Auslösung weiter eingegangen, da insbesondere für diese Fälle das beschriebene Kriterium angewendet werden kann. Einpolig ausgelöst wird in der Regel nur bei einphasigen Fehlern; eine einpolige Auslösung ist aber auch bei zweiphasigen Fehlern ohne Erdbeteiligung möglich. Desweiteren kann das beschriebe Verfahren nur dann angewendet werden, wenn die Spannungswandler leitungsseitig angeschlossen sind (vgl. Figuren 1 und 2).

Ob bei einem temporären Fehler die einpolige automatische Wiedereinschaltung erfolgreich ist, hängt primär davon ab, ob der beim Öffnen der Schaltkontakte hervorgerufene Lichtbogen während der Pausenzeit erlischt, bzw. die Lichtbogenstrecke entionisiert ist.

Die einpolige automatische Wiedereinschaltung verhindert bei temporären Fehlern eine länger dauernde Abschaltung der betroffenen Phase und erhöht somit die Versorgungszuverlässigkeit des Netzes. Ein Nebeneffekt der einpoligen automatischen Wiedereinschaltung ist die Entstehung eines stromschwachen Lichtbogens, der durch die kapazitive und induktive Kopplung durch die beiden nicht unterbrochenen Leiter gespeist wird.

Wie ein stromschwacher Lichtbogen erkannt wird, ist z.B. in dem Aufsatz "Beurteilung der Lichtbogenlöschung bei der einpoligen AWE in Höchstspannungsnetzen (Rainer Luxenburger, TU Dresden, Andrea Ludwig, Vattenfall Europe Transmission GmbH, Peter Schegner, TU Dresden)" beschrieben.

Durch die Fähigkeit, permanente Fehler von temporären Fehlern zu unterscheiden, kann ein Signal zur Anzeige eines möglicherweise bewusst hervor geführten Kurzschlusses zum Zweck des Leitungsdiebstahls erzeugt werden. Hierbei gibt es drei mögliche Szenarien, die zu betrachten sind.

Hierzu sei angenommen, dass eine Person eine Abschaltung einer Leitung absichtlich herbeiführen will. Hierzu bringt die Person z.B. einen Gegenstand mit der Leitung in Kontakt (z.B. wirft sie den Gegenstand in die Leitung oder bringt eine Baggerschaufel mit der Leitung in Kontakt), wobei der Gegenstand einen Kurzschluss verursacht (einphasig mit Erde oder zweiphasig). Das die Leitung überwachende Schutzgerät löst hierbei einpolig aus.

Hierbei besteht einerseits die Möglichkeit, dass der Gegenstand auf der Leitung verbleibt und nicht verbrennt und damit einen permanenten Fehler erzeugt. Da nach Ablauf der Pausenzeit der automatischen Wiedereinschaltung der Kurzschluss noch weiter vorliegt, findet eine erfolglose Wiedereinschaltung statt. Die Leitung wird schließlich endgültig abgeschaltet.

Andererseits besteht die Möglichkeit, dass der Gegenstand verbrennt oder sich wieder von der Leitung löst, so dass ein temporärer Fehler vorliegt. Dabei entsteht wie oben beschrieben ein stromschwacher Lichtbogen. Dies wird vom Schutzgerät erkannt.

Dabei kann es gemäß einer ersten Alternative vorkommen, dass der stromschwache Lichtbogen nicht während der Pausenzeit erlischt. Eine einpolige automatische Wiedereinschaltung ist somit erfolglos. Danach wird ein dreipoliger Wiedereinschaltungs-Zyklus eingeleitet. Der stromschwache Lichtbogen erlischt hierdurch und die Leitung kann wieder in den normalen Betrieb übergehen.

Gemäß einer zweiten Alternative kann es vorkommen, dass der stromschwache Lichtbogen während der Pausenzeit erlischt. Es kommt zu einer erfolgreichen Wiedereinschaltung. Die Leitung kann wieder in den normalen Betrieb übergehen.

Da die die Leitung manipulierende Person an einer vollständigen Abschaltung der Leitung interessiert ist, muss sie das beschriebene Szenario, ggf. mehrfach, wiederholen. In der Regel wird nämlich nach mehreren Zyklen einer automatischen Wiedereinschaltung die Leitung endgültig außer Betrieb genommen, da dann damit zu rechnen ist, dass ein dauerhaftes Problem vorliegt.

Mit der beschriebenen Vorgehensweise gemäß Block 40 wird als Ergebnis ein Wahrscheinlichkeitswert $P_1$ erzeugt, dessen Höhe davon abhängt, ob das Kriterium ganz oder teilweise erfüllt worden ist. Folgende Möglichkeiten zur Bildung des Wahrscheinlichkeitswerts $P_1$ bestehen:

$P_1$ wird größer, wenn mehrmals innerhalb einer vorgegeben Zeitdauer ein stromschwacher Lichtbogen erkannt wurde, obwohl es zu erfolgreichen Wiederzuschaltungen gekommen ist. Dies deutet nämlich darauf hin, dass eine Person mehrmals hintereinander Gegenstände mit der Leitung in Kontakt bringt, um letztlich eine vollständige Abschaltung zu erzwingen.

$P_1$ wird größer, wenn ein Kurzschluss ohne Entstehung eines stromschwachen Lichtbogens erkannt wird, d.h. permanenter Fehler vorliegt. Dies ist vertretbar, da laut Statistiken ca. 90% der Fehler temporäre Fehler sind und somit ein permanenter Fehler ein höheres Risiko einer Fremdeinwirkung besitzt.

Gemäß einem zweiten Kriterium findet eine Auswertung eines Fehlerwiderstandes statt (Block 41).

Der Fehlerwiderstand kann beispielsweise im Zusammenhang mit einem Fehlerortungsverfahren nach der Reaktanzmethode ermittelt werden. Leitungsschutzgeräte verfügen nämlich in der Regel über eine Fehlerortungsfunktion, mittels der nach Abschaltung des Fehlers durch Messung der Impedanz $X_L$ die Entfernung zur Fehlerstelle bestimmt werden kann. Mit einer geeigneten Fehlerortungsfunktion, z.B. nach der Reaktanzmethode, kann die Entfernung zur Fehlerstelle einerseits verhältnismäßig genau bestimmt werden. Außerdem kann mit dieser Berechnungsmethode auch der Fehlerwiderstand $R_F$ bestimmt werden.

Kurzschlüsse, die z.B. durch Blitzeinschlag, Pflanzenwuchs oder Verschmutzung der Isolatoren hervorgerufen werden, führen in der Regel zur Entstehung eines Lichtbogens. Dieser Lichtbogen weist einen Fehlerwiderstand $R_F$ auf, der von der Fehlerortungsfunktion bestimmt werden kann. Liegt in einem Kabel ein Defekt der Isolation vor, dann brennt an der Fehlerstelle ebenfalls ein Lichtbogen.

Ein mutwillig durch Gegenstände, einen Bagger oder einen Kran hervorgerufener Kurzschluss wird hingegen ein metallischer Kurzschluss sein. Der Fehlerwiderstand $R_F$ ist in diesen Fällen sehr klein.

Die Größe des Fehlerwiderstandes $R_F$ ist daher dazu geeignet, einen Hinweis darauf zu liefern, ob ein Kurzschluss mutwillig hervorgerufen wurde oder nicht. Sehr geringe Fehlerwiderstände deuten auf einen absichtlich herbeigeführten Fehler hin. Die Genauigkeit der Fehlerortungsfunktion ist außerdem davon abhängig, ob eine einseitige (vgl. Figur 1) oder eine zweiseitige (vgl. Figur 2) Messung durchgeführt wurde oder wegen fehlender Messung am Gegenende oder fehlender Kommunikationsverbindung zwischen den Schutzgeräten nur eine einseitige Messung möglich war.

Zur Festlegung des mit diesem Kriterium ermittelten Wahrscheinlichkeitswertes $P_3$ ist somit auch zu berücksichtigen, ob eine einseitige oder eine zweiseitige Fehlerortsbestimmung durchgeführt worden ist. Bei einer einseitigen Messung ist die Genauigkeit wegen fehlender Kenntnis der Vorimpedanzen geringer. Daher sollte in diesem Fall der $P_3$ zugewiesene Wahrscheinlichkeitswert kleiner sein, als bei einer zweiseitigen Messung. Die Festlegung des Wahrscheinlichkeitswertes $P_3$ findet gemäß Figur 4 in Block 42 anhand des Fehlerwiderstandes $R_F$ statt.

In Figur 5 sind hierzu lediglich beispielhaft mögliche Kennlinien für die Fehlerortsbestimmung mit einseitiger (Kennlinie 50) oder zweiseitiger (Kennlinie 51) Messung dargestellt. Der Maximalwert $P_{3,max,1\text{-end}}$ bzw. $P_{3,max,2\text{-end}}$, also der jeweils höchste Wahrscheinlichkeitswert wird nur dann erreicht, wenn für den Fehlerwiderstand $R_F$ der Wert 0 ermittelt wurde. Überschreitet der Fehlerwiderstand den Wert $R_{F,max,1\text{-end}}$ bzw. $R_{F,max,\ 2\text{-end}}$, dann ist ein mutwillig hervorgerufener Kurzschluss sehr unwahrscheinlich, der Wahrscheinlichkeitswert $P_3$ wird auf 0 gesetzt.

Gemäß einem dritten Kriterium wird schließlich das Vorliegen einer dauerhaften Trennstelle mit Hilfe der nach einer Zuschaltung entstehenden Transienten überprüft.

Temporäre Kurzschlüsse auf Übertragungsleitungen können wie oben erläutert mithilfe einer automatischen Wiedereinschaltung geklärt werden. Die Unterbrechung des Stromflusses durch das Öffnen eines Leistungsschalters in einer kurzgeschlossenen Schleife führt oft zur Erlöschung des durch Blitzeinschlag, Pflanzenbewuchs oder Verschmutzung hervorgerufenen Lichtbogens. Nach einer Wiederzuschaltung des Leistungsschalters wird der Normalbetrieb der Leitung weitergeführt. Die Erkennung, ob weiterhin ein Fehler vorliegt, wird z.B. durch Strommessung oder Prüfung der Anregesignale der Schutzfunktionen eines Schutzgerätes realisiert.

In der Regel erfolgt nach einem erfolglosen Wiedereinschaltungszyklus eine endgültige Abschaltung. In Ausnahmefällen werden mehrere Wiedereinschaltungszyklen durchgeführt, um den Kurzschluss zu beseitigen. Spätestens nach mehreren erfolglosen Wiedereinschaltungszyklen wird auf einen permanenten Kurzschluss entschieden und die kurzschlussbehaftete Leitung vom Netz getrennt. Erst nach der Beseitigung des an der Fehlerstelle vorliegenden Schadens durch ein Wartungsteam wird die Leitung manuell zugeschaltet.

Im Falle eines absichtlich herbeigeführten Kurzschlusses, z.B. zum Zwecke eines Leitungsdiebstahls, werden die Leitungen von einem Dritten absichtlich in den Zustand des permanenten Kurzschlusses geführt. Erst im spannungslosen Zustand werden die Leitungen entfernt. Somit entsteht durch die Entfernung der Leitungen eine dauerhafte Trennstelle auf der Leitung.

Um einen sicheren Hinweis auf diese dauerhafte Trennstelle zu erhalten, muss die Leitung zur Prüfung des dritten Kriteriums nach einer Wartezeit wieder kurzzeitig zugeschaltet werden. Dabei werden durch Reflektion an den Leiterenden Transienten generiert, deren Verlauf charakteristisch für den Ort der vorliegenden Trennstelle ist. Die temporäre Wiedereinschaltung und die Messung und Auswertung der Transienten wird gemäß Figur 4 in einem Block 43 durchgeführt. Hierbei wird wie nachfolgend detaillierter dargestellt neben der bloßen Information über das Vorliegen einer Trennstelle deren Entfernung $d_U$ von der Messstelle ermittelt.

Die Transienten lassen sich durch das mathematische Modell der Leitung in einer verteilten Parameterausführung abbilden. Man geht hierbei davon aus, dass an der Trennstelle kein Strom fließt. Der Strom an der Trennstelle lässt sich bei einem einphasigen System durch folgende Gleichung im Frequenzbereich definieren:

$$I(x, j\omega) = -\frac{1}{Z_c(j\omega)} U_1(j\omega) \sinh \gamma(j\omega)x + I_1(j\omega) \cosh \gamma(j\omega)x$$

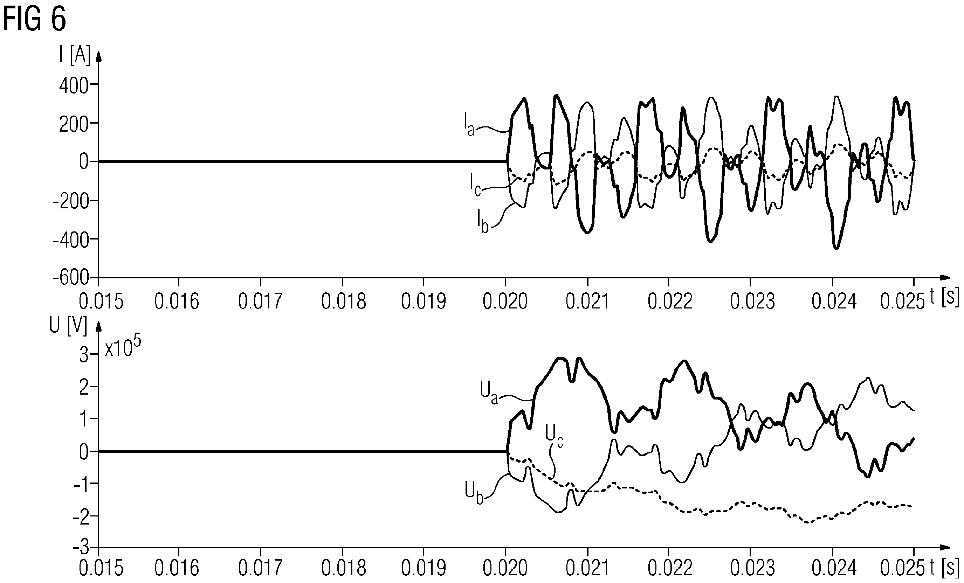

$U_1$ und $I_1$ sind die gemessenen Größen. $\gamma$ ist eine Propagationskonstante und $Z_c$ ist eine Wellenimpedanz. Es wird nach einer unbekannten Trennstelle x gesucht, wo der Strom I bei (oder nahe bei) Null liegt. Da der Schaltvorgang mit einer Vielzahl auftretender Transienten verbunden ist, wird erwartet, dass jede gemessene harmonische Schwingung im Strom und in der Spannung, die auf den Strom an der Trennstelle umgerechnet wird, sehr klein ist. Figur 6 zeigt beispielhaft den Verlauf der Ströme I und Spannungen U bei einer temporären Wiedereinschaltung der Leitung zur Ermittlung des Vorhandenseins und der Lage einer Trennstelle. Bei t=0,02s findet die temporäre Wiedereinschaltung statt.

Dreiphasige Systeme können entsprechend in sogenannte modale Systeme umgewandelt werden und dann einphasig betrachtet werden. Zur Umwandlung in modale Systeme wird die $\alpha\beta0$-Transformation (auch bekannt als "Clark-Transformation") verwendet:

$$\begin{bmatrix} I_\alpha \\ I_\beta \\ I_0 \end{bmatrix} = \frac{1}{3} \begin{bmatrix} 2 & -1 & -1 \\ 0 & \sqrt{3} & \sqrt{3} \\ 1 & 1 & 1 \end{bmatrix} \begin{bmatrix} I_a \\ I_b \\ I_c \end{bmatrix}, \qquad \begin{bmatrix} U_\alpha \\ U_\beta \\ U_0 \end{bmatrix} = \frac{1}{3} \begin{bmatrix} 2 & -1 & -1 \\ 0 & \sqrt{3} & \sqrt{3} \\ 1 & 1 & 1 \end{bmatrix} \begin{bmatrix} U_a \\ U_b \\ U_c \end{bmatrix}$$

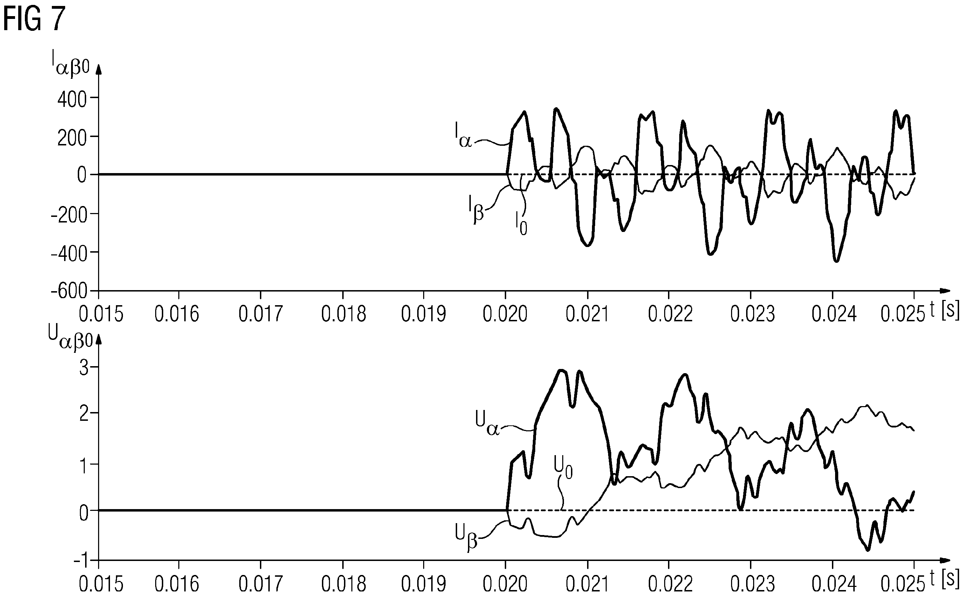

In Figur 7 sind beispielhaft die modalen Komponenten der in Figur 6 gezeigten Ströme und Spannungen aufgetragen.

Für die Modalkomponenten wird eine separate Berechnung durchgeführt:

$$I_{\alpha\beta0}(x, j\omega) = -\frac{1}{Z_{c\alpha\beta0}(j\omega)} U_{1\alpha\beta0}(j\omega) \sinh \gamma_{\alpha\beta0}(j\omega)x + I_{1\alpha\beta0}(j\omega) \cosh \gamma_{\alpha\beta0}(j\omega)x$$

Die Inverse-Operation an der Transformationsmatrix führt zur Wiederkehr in die Phasengrößen. Dann können die Ströme separat ausgewertet werden:

$$\begin{bmatrix} I_a \\ I_b \\ I_c \end{bmatrix} = 3 \begin{bmatrix} 2 & -1 & -1 \\ 0 & \sqrt{3} & \sqrt{3} \\ 1 & 1 & 1 \end{bmatrix}^{-1} \begin{bmatrix} I_\alpha \\ I_\beta \\ I_0 \end{bmatrix} \rightarrow \begin{bmatrix} 0 \\ 0 \\ 0 \end{bmatrix} = 3 \begin{bmatrix} 1 & 0 & 1 \\ -\dfrac{1}{2} & \dfrac{\sqrt{3}}{2} & 1 \\ -\dfrac{1}{2} & \dfrac{\sqrt{3}}{2} & 1 \end{bmatrix} \begin{bmatrix} I_\alpha \\ I_\beta \\ I_0 \end{bmatrix}_x$$

Es wird sodann nach einer Trennstelle x gesucht, die die oben gegebenen Bedingungen erfüllt, an der nämlich der Strom bei oder nahe bei Null liegt. Dafür kann eine Zielfunktion pro Phase erstellt werden, die den Amplitudenwert des Stroms minimiert. Z.B. gilt für Phase A folgende Gleichung:

$$\min_x \left\| \left( I_\alpha + I_\beta \right) \right\|$$

Als Beispiel sei ein 230kV-System mit einer Leitung gewählt, die 150km lang ist und beidseitig gespeist wird. Das nachfolgend beschriebene Verfahren kann selbstverständlich auch in anderen, insbesondere niedrigeren, Spannungsebenen eingesetzt werden. Die beispielhafte Leitung hat bei Nennfrequenz folgende Parameter:

$$Z = \begin{bmatrix} 0.187 + j0.858 & 0.098 + j0.3705 & 0.098 + j0.3705 \\ 0.098 + j0.3705 & 0.187 + j0.858 & 0.098 + j0.3705 \\ 0.098 + j0.3705 & 0.098 + j0.3705 & 0.187 + j0.858 \end{bmatrix} \Omega$$

$$Y = 1e-5 \begin{bmatrix} j0.3 & -j0.036 & -j0.036 \\ -j0.036 & j0.3 & -j0.036 \\ -j0.036 & -j0.036 & j0.3 \end{bmatrix} S$$

Dabei steht Z für die Leitungsimpedanz und Y für die Leitungsadmittanz.

Die oben angegebenen Matrizen ergeben sich aus der Geometrie der Masten sowie Parameter des Erdreiches. Diese sind dem Netzbetreiber bekannt bzw. können aus den Grunddaten der Leitung ermittelt werden.

Die Modaltransformation führt zur Entkopplung der Phasengrößen:

$$Z_{\alpha\beta0} = TZT^{-1} = \begin{bmatrix} 0.0894 + j0.487 & 0 & 0 \\ 0 & 0.0894 + j0.487 & 0 \\ 0 & 0 & 0.383 + j1.599 \end{bmatrix} \Omega$$

$$Y_{\alpha\beta0} = TYT^{-1} = 1e^{-5} \begin{bmatrix} j0.336 & 0 & 0 \\ 0 & j0.336 & 0 \\ 0 & 0 & j0.229 \end{bmatrix} S$$

Es entstehen Diagonalmatrizen, die darauf hinweisen, dass die Berechnung des Systems separat in Modalkomponenten durchführbar ist. Um das Modell mit verteilten Parametern zu verwenden, müssen zusätzliche Parameter berechnet werden. Das sind die Propagationskonstante sowie die Wellenimpedanz:

$$\gamma_{\alpha\beta 0} = \begin{bmatrix} 0.0001 + j0.00128 & 0 & 0 \\ 0 & 0.0001 + j0.00128 & 0 \\ 0 & 0 & 0.0002 + j0.0019 \end{bmatrix}$$

$$Z_{C\alpha\beta 0} = 1e + 2 \begin{bmatrix} 3.821 - j0.3475 & 0 & 0 \\ 0 & 3.821 - j0.3475 & 0 \\ 0 & 0 & 8.411 - j0.994 \end{bmatrix} \Omega$$

Da man in einem breiteren Frequenzspektrum die Berechnung durchführt, müssen diese beiden Hauptparameter pro betrachteter Frequenz ermittelt werden. Es wird davon ausgegangen, dass diese Parameter linear frequenzabhängig sind. Die Frequenzauflösung hängt von dem gewählten Messfenster ab. Die zu berechnende Frequenzbandbreite hängt von der gewählten Abtastfrequenz ab. Es ist zu empfehlen, mindestens 16kHz als Abtastrate zu wählen. Wählt man ein System mit einer zu niedrigen Abtastrate, dann wird man keine Transienten erfassen und dann nicht sicher auf Trennstelle schließen können. Die hier durchgeführten Betrachtungen basieren auf einem Schutzgerät mit einem Messsystem, das mit einer Abtastrate von 64kHz arbeitet.

Die Vorgehensweise zur Ermittlung der Lage der Trennstelle ist wie folgt:
In einem ersten Schritt werden während der Zuschaltung die Ströme und Spannungen an der durchgetrennten Leitung messtechnisch erfasst (vgl. Figur 6). Figur 6 ist zu entnehmen, dass nach der Zuschaltung der Leitung signifikante Transienten auftreten, die den Hinweis auf die Trennstelle liefern. Die Frequenz der Transienten hängt nämlich von der Entfernung der Trennstelle ab und lässt sich durch den Reflektionsmechanismus der entstehenden Wanderwellen erklären. Je weiter die Trennstelle entfernt ist, desto niedriger sind die auftretenden Frequenzen.

In einem zweiten Schritt werden aus den Verläufen von Strom und Spannung zur Entkopplung des Dreiphasensystems die modalen Komponenten gebildet (Figur 7). Nach der Transformation gehen die Transienten nicht verloren; vielmehr lassen sich ihre Ausbreitung und das Verhalten einfacher interpretieren.

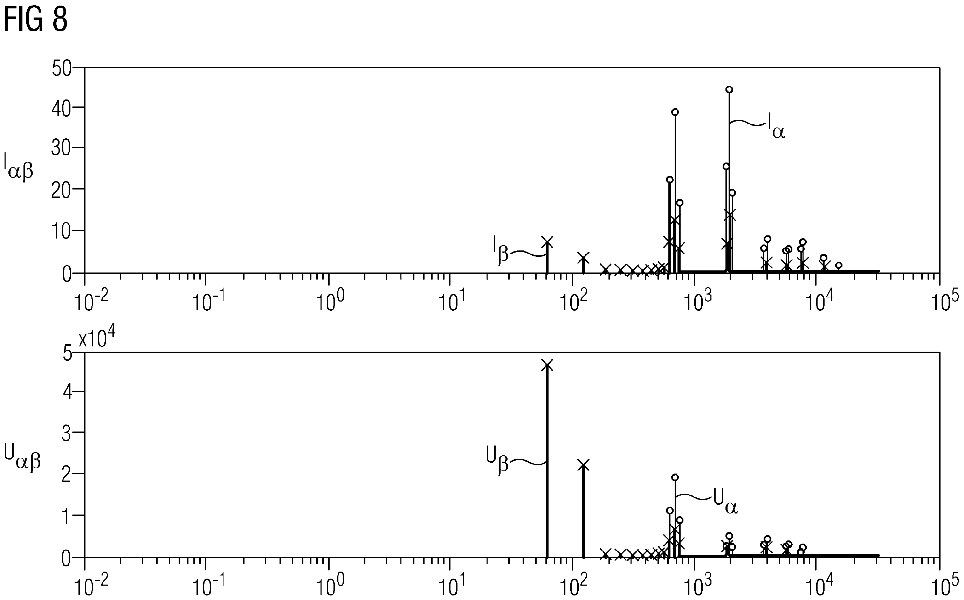

In einem dritten Schritt werden die modalen Komponenten im Frequenzbereich abgebildet (Figur 8). Für die einfache Berechnung ist die Transformation in Frequenzbereich hilfreich Die zeitbasierten Modelle sind zwar genauer, allerdings benötigen sie auch mehr Rechenleistung. Darüber hinaus ist im Frequenzbereich die Berücksichtigung von Messeinflüssen (z.B. durch die Messwandler) wesentlich einfacher.

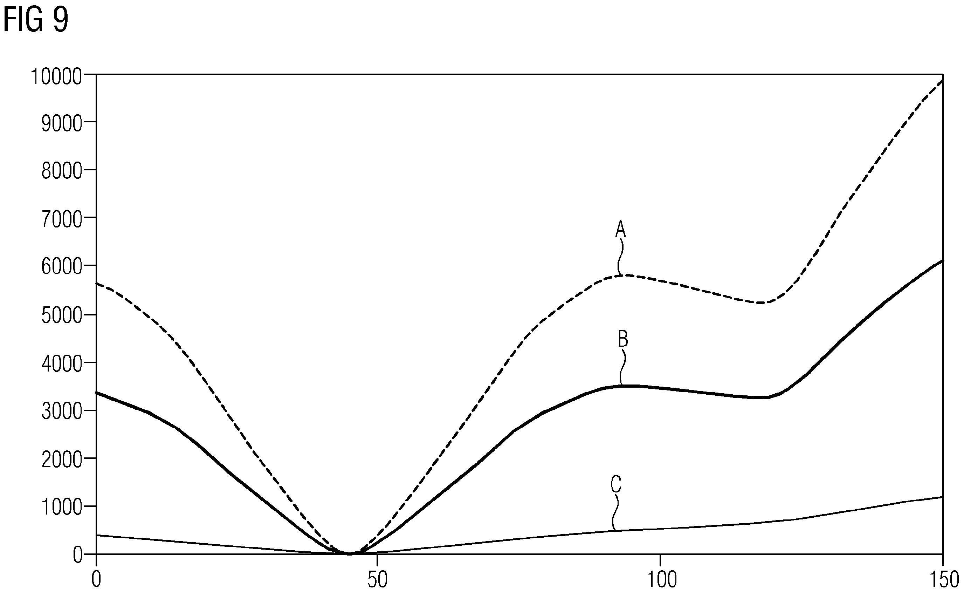

In einem vierten Schritt werden mit einer Variablen x die Berechnungen in Modalkomponenten durchgeführt und in Phasengrößen zurücktransformiert. Die erstellte Zielfunktion liefert für die drei Phasen A, B, C den Hinweis über Position der Trennstelle (Figur 9). Die in Figur 9 dargestellte Zielfunktion zeigt ein Minimum und damit die Trennstelle bei 45 km vom einen Leitungsende. Der Figur 9 ist zu entnehmen, dass das Minimum der Zielfunktion auf die Trennstelle hinweist. Die Zielfunktion ist so definiert, dass sie einen kumulierten Inhalt an harmonischen Schwingungen liefert. Der Inhalt der Harmonischen ist an der Trennstelle am niedrigsten. Somit lässt sich auf diese Weise die Lage x der Trennstelle bzw. die Entfernung $d_U$ der Trennstelle vom einen Leitungsende ermitteln.

Allein das Vorhandensein einer dauerhaften Trennstelle gibt einen Hinweis auf einen absichtlich herbeigeführten Fehler, daraus lässt sich ein Wahrscheinlichkeitswert $P_2$ bestimmen, der bei Vorliegen der Trennstelle sein Maximum annimmt.

In einem Block 44 werden die Wahrscheinlichkeitswerte $P_1$, $P_2$, $P_3$ miteinander verknüpft, z.B. durch Addition. Liegt der resultierende Gesamt-Wahrscheinlichkeitswert $\sum P$ über einem Wahrscheinlichkeits-Schwellenwert $P_{Alarm}$, was in einem Vergleichsblock 45 festgestellt werden kann, so wird ein Alarmsignal ausgegeben.

Außerdem kann in einem optionalen Schritt ein mittels einer Fehlerortungsfunktion (z.B. im Zusammenhang mit der Berechnung des Fehlerwiderstandes $R_F$ auf Basis der Leitungsreaktanz $X_L$) eine Berechnung des Fehlerortes d (Abstand des Fehlerortes vom einen Leitungsende) stattfinden. Dies kann in einem optionalen Block 46 stattfinden. Dieser Fehlerort d kann in einem weiteren optionalen Block 47 mit der Lage der Trennstelle $d_U$ verglichen werden. Wenn beide Werte d und $d_U$ nahezu übereinstimmen, dann kann auf einen Leitungsdiebstahl geschlossen werden, da in diesem Fall die Trennstelle an derjenigen Stelle erzeugt worden ist, wo auch der Fehler absichtlich herbeigeführt worden ist.

Der beschriebene Mechanismus funktioniert auch dann, wenn die Trennung nicht vollständig erfolgt ist und es einige nicht durchtrennte Leiter gibt.

Bei Durchführung dieser optionalen Prüfungen kann eine Bestimmung des Wahrscheinlichkeitswertes $P_2$ auch unter zusätzlicher Heranziehung des Fehlerortes wie folgt stattfinden.

Wenn keine Trennstelle ermittelt werden konnte, ist der Wahrscheinlichkeitswert $P_2$ = 0. Wenn mit Hilfe der Transienten eine Unterbrechungsstelle gefunden wurde und auch ein Ergebnis des Fehlerorters vorliegt, dann ist die Wahrscheinlichkeit $P_2$ eine Funktion der Differenz $\Delta d$ aus dem Fehlerort $d$ und der Lage der ermittelten Trennstelle $d_U$. Ein mittels eines Fehlerorters bestimmter Fehlerort und die Lage der ermittelten Trennstelle sollten im Rahmen der Messgenauigkeit identisch sein, sofern der Fehler absichtlich herbeigeführt wurde, um die Leitung an dieser Stelle nach Abschaltung aufzutrennen.

$$\Delta d = \left| d - d_U \right|$$

Wenn $\Delta d$ größer als ein festzulegender Schwellenwert $\Delta d_{max}$ ist, dann ist die Wahrscheinlichkeit $P_2 = 0$. Anderenfalls wird $P_2$ nach einer zu bestimmenden Funktion, z.B. einer linearen Funktion, ermittelt:

$$P_2 = f\left(\Delta d\right)$$

Außerdem kann in einem weiteren optionalen Block 48 überprüft werden, ob der ermittelte Fehlerort in einem als risikoreich angesehenen Gebiet (z.B. dünn besiedeltes Gebiet oder ein Gebiet, in dem sich statistisch die Leitungsdiebstähle häufen) liegt. In diesem Fall kann vorgesehen sein, dass das Alarmsignal nur dann abgegeben wird, wenn diese Prüfung die Lage des Fehlerortes in einem risikoreichen Gebiet liegt. Dies wird durch ein UND-Glied 49 erreicht.

Ein weiteres im Zusammenhang mit Figur 4 nicht beschriebenes Kriterium kann zudem die Anzahl der erfolglosen Wiedereinschaltzyklen sein. Eine endgültige Abschaltung durch die automatische Wiedereinschaltungsfunktion gibt dann einen Hinweis auf einen absichtlich hervorgerufenen Kurzschluss.

Gemäß dieser zweiten beschriebenen Ausführungsform erhält der Netzbetreiber unmittelbar nach einem Fehler einen Hinweis in Form des Alarmsignals, dass der Fehler möglicherweise absichtlich hervorgerufen wurde. Bei einem entsprechenden Verdacht kann wesentlich schneller Sicherheitspersonal oder Polizei zur Fehlerstelle geschickt werden. Die Auswertung der beschriebenen Kriterien und deren Verknüpfung tragen wesentlich dazu bei, dass eine zeitnahe Entscheidung zur Bildung der Alarm-Meldung getroffen werden kann. Durch die kombinierte Analyse aller genannten Kriterien kann die Wahrscheinlichkeit eines absichtlich herbeigeführten Fehlers zudem mit viel größerer Genauigkeit angegeben werden, als wenn diese Entscheidung ohne eine solche Prüfung getroffen werden würde.

Ein weiterer Vorteil besteht darin, dass die fragliche Funktion in ein Schutzgerät integriert werden kann, welches ohnehin im Energieversorgungsnetz installiert werden muss. Für die Realisierung dieser Funktion entstehen dem Anwender also keine zusätzlichen Hardwarekosten.

**Patentansprüche**

1. Verfahren zum Ermitteln einer Ursache eines Fehlers in einem elektrischen Energieversorgungsnetz (11, 21a, 21b), bei dem

- an mindestens einer Messstelle (12) des Energieversorgungsnetzes (11, 21a, 21b) elektrische Messgrößen erfasst werden; und
- die elektrischen Messgrößen mindestens einem Schutzgerät (13) zugeführt werden, das die Messgrößen hinsichtlich des Vorliegens eines Fehlers in dem elektrischen Energieversorgungsnetz (11, 21a, 21b) untersucht und im Falle eines erkannten Fehlers ein Fehlersignal erzeugt, wobei
- nach der Erkennung eines Fehlers von dem mindestens einen Schutzgerät (13) unmittelbar vor und/oder während des Fehlers erfasste zeitliche Verläufe der Messgrößen hinsichtlich des Vorliegens bestimmter Kriterien untersucht werden, wobei den einzelnen Kriterien und/oder Kombinationen von Kriterien mögliche Ursachen von Fehlern zugeordnet sind;
- ein oder mehrere Kriterien ermittelt werden, die von den untersuchten Verläufen der Messgrößen ganz oder teilweise erfüllt sind; und
- abhängig von den ermittelten Kriterien und dem Grad ihrer Erfüllung durch die Verläufe eine Ursache des Fehlers ermittelt wird;
**dadurch gekennzeichnet, dass**
- zumindest einige der Kriterien dazu geeignet sind, absichtlich herbeigeführte Fehler zu erkennen, wobei
- als auf einen absichtlich herbeigeführten Fehler hindeutende Kriterien mehrere der folgenden Kriterien verwendet werden:

- die Erkennung eines permanent vorliegenden Fehlers;
- die Erkennung einer wiederholten automatischen Aus- und Einschaltung einer Phase einer Leitung innerhalb eines vorgegebenen Zeitraums;
- ein Fehlerwiderstand, der unterhalb eines vorgegebenen Schwellenwertes liegt; und

- sofern die Überprüfung ergibt, dass der Fehler absichtlich herbeigeführt worden ist, ein Alarmsignal erzeugt wird, das auf einen möglichen Leitungsdiebstahl hindeutet.

2. Verfahren nach Anspruch 1,
   **dadurch gekennzeichnet, dass**

   - von dem mindestens einen Schutzgerät (13) ein Signal abgegeben wird, das die ermittelte Ursache angibt.

3. Verfahren nach einem der Anspruch 1 oder 2,
   **dadurch gekennzeichnet, dass**

   - als auf einen absichtlich herbeigeführten Fehler hindeutendes Kriterium eine auf einer fehlerbehafteten Leitung erkannte Trennstelle verwendet wird.

4. Verfahren nach Anspruch 3,
   **dadurch gekennzeichnet, dass**

   - zur Überprüfung, ob eine Trennstelle vorliegt, während einer temporären Wiedereinschaltung der fehlerbehafteten Leitung sich auf der Leitung ausbreitende Wanderwellen des Stroms und/oder der Spannung untersucht werden, wobei die Trennstelle an derjenigen Stelle der Leitung erkannt wird, an der eine den Stromverlauf entlang der fehlerbehafteten Leitung angebende Zielfunktion ein Minimum aufweist.

5. Verfahren nach Anspruch 4,
   **dadurch gekennzeichnet, dass**

   - nach dem Eintritt des Fehlers eine Fehlerortung durchgeführt wird und der ermittelte Fehlerort mit dem Ort der ermittelten Trennstelle verglichen wird; und
   - der Erfüllungsgrad des Kriteriums hinsichtlich einer vorliegenden Trennstelle in Abhängigkeit vom Abstand zwischen dem Fehlerort und der Lage der Trennstelle ermittelt wird.

6. Verfahren nach einem der vorangehenden Ansprüche ,
   **dadurch gekennzeichne**t, dass

   - aus dem jeweiligen Erfüllungsgrad der einzelnen auf einen absichtlich herbeigeführten Fehler hinweisenden Kriterien jeweils Wahrscheinlichkeitswerte ermittelt werden, die die Wahrscheinlichkeit angeben, dass die Erfüllung des jeweiligen Kriteriums tatsächlich einen absichtlich herbeigeführten Fehler bedeutet;
   - durch Verknüpfung der einzelnen Wahrscheinlichkeitswerte ein Gesamt-Wahrscheinlichkeitswert ermittelt wird;
   - der Gesamt-Wahrscheinlichkeitswert mit einem Wahrscheinlichkeits-Schwellenwert verglichen wird; und
   - das Alarmsignal erzeugt wird, wenn der Gesamt-Wahrscheinlichkeitswert den Wahrscheinlichkeits-Schwellenwert übersteigt.

7. Verfahren nach einem der vorangehenden Ansprüche,
   **dadurch gekennzeichnet, dass**

   - das Schutzgerät (13) einen Fehler in dem Energieversorgungsnetz (11, 21a, 21b) mittels einer Distanzschutzfunktion erkennt; und
   - eine Information über die mit der Distanzschutzfunktion erkannte Entfernung des Fehlers von der dem Schutzgerät (13) zugeordneten Messstelle dem Alarmsignal beigefügt wird.

8. Verfahren nach einem der Ansprüche 1 bis 6,
   **dadurch gekennzeichnet, dass**

- nach dem Eintritt des Fehlers von dem Schutzgerät (13) eine Fehlerortung durchgeführt wird; und
- eine Information über den ermittelten Fehlerort dem Alarmsignal beigefügt wird.

9. Schutzgerät (13) zum Ermitteln einer Ursache eines Fehlers in einem elektrischen Energieversorgungsnetz (11, 21a, 21b), wobei das Schutzgerät (13) eine Recheneinrichtung (32) aufweist, die dazu eingerichtet ist,

- unter Verwendung von an mindestens einer Messstelle (12) des Energieversorgungsnetzes (11, 21a, 21b) erfasster elektrischer Messgrößen eine Untersuchung hinsichtlich des Vorliegens eines Fehlers in dem elektrischen Energieversorgungsnetz (11, 21a, 21b) durchzuführen; und
- im Falle eines erkannten Fehlers ein Fehlersignal zu erzeugen;
wobei
- die Recheneinrichtung (32) dazu eingerichtet ist, nach der Erkennung eines Fehlers unmittelbar vor und/oder während des Fehlers erfasste zeitliche Verläufe der Messgrößen hinsichtlich des Vorliegens bestimmter Kriterien zu untersuchen, wobei den einzelnen Kriterien und/oder Kombinationen von Kriterien mögliche Ursachen von Fehlern zugeordnet sind;
- ein oder mehrere Kriterien zu ermitteln, die von den untersuchten Verläufen der Messgrößen ganz oder teilweise erfüllt sind; und
- abhängig von den ermittelten Kriterien und dem Grad ihrer Erfüllung durch die Verläufe eine Ursache des Fehlers zu ermitteln,
**dadurch gekennzeichnet, dass** - zumindest einige der Kriterien dazu geeignet sind, absichtlich herbeigeführte Fehler zu erkennen, wobei als auf einen absichtlich herbeigeführten Fehler hindeutende Kriterien mehrere der folgenden Kriterien verwendet werden:

- die Erkennung eines permanent vorliegenden Fehlers;
- die Erkennung einer wiederholten automatischen Aus- und Einschaltung einer Phase einer Leitung innerhalb eines vorgegebenen Zeitraums;
- ein Fehlerwiderstand, der unterhalb eines vorgegebenen Schwellenwertes liegt; und
- die Recheneinrichtung dazu eingerichtet ist, ein Alarmsignal zu erzeugen, das auf einen möglichen Leitungsdiebstahl hindeutet, sofern die Überprüfung ergibt, dass der Fehler absichtlich herbeigeführt worden ist.

**Claims**

1. Method for determining a cause of a fault in an electrical energy supply network (11, 21a, 21b), in which

- electrical measurement variables are detected at at least one measurement point (12) of the energy supply network (11, 21a, 21b); and
- the electrical measurement variables are fed to at least one protective device (13), which examines the measurement variables with respect to the presence of a fault in the electrical energy supply network (11, 21a, 21b), and generates a fault signal in the event of an identified fault, wherein
- after a fault has been identified by the at least one protective device (13), time profiles of the measurement variables with respect to the presence of specific criteria are examined, said time profiles having been detected immediately before and/or during the fault, wherein possible causes of faults are assigned to the individual criteria and/or combinations of criteria;
- one or more criteria that are entirely or partially fulfilled by the examined profiles of the measurement variables are determined; and
- a cause of the fault is determined on the basis of the determined criteria and the degree to which they are fulfilled by the profiles;
**characterized in that**
- at least some of the criteria are suitable for identifying deliberately caused faults, wherein
- a plurality of the following criteria are used as criteria that indicate a deliberately caused fault:

- identification of a permanently present fault;
- identification of repeated, automatic disconnection and connection of a phase of a line within a predefined time period;
- a fault resistance that is below a predefined threshold value; and

- if the check reveals that the fault has been caused deliberately, an alarm signal that indicates a possible line theft is generated.

2. Method according to Claim 1, **characterized in that**

- a signal that indicates the determined cause is output by the at least one protective device (13).

3. Method according to either of Claims 1 and 2, **characterized in that**

- a disconnection point identified on a faulty line is used as the criterion that indicates a deliberately caused fault.

4. Method according to Claim 3, **characterized in that**

- during temporary reclosing of the faulty line, traveling waves of the current and/or voltage that propagate on the line are examined in order to check whether there is a disconnection point, wherein the disconnection point is identified at that location of the line at which a target function that indicates the current profile along the faulty line has a minimum.

5. Method according to Claim 4, **characterized in that**

- after the occurrence of the fault, fault locating is performed and the determined fault location is compared with the location of the determined disconnection point; and
- the degree to which the criterion with respect to a present disconnection point is fulfilled is determined on the basis of the distance between the fault location and the location of the disconnection point.

6. Method according to one of the preceding claims, **characterized in that**

- respective probability values are determined from the respective degree to which the individual criteria that indicate a deliberately caused fault are fulfilled, said probability values indicating the probability that the fulfilment of the respective criterion actually signifies a deliberately caused fault;
- an overall probability value is determined by combining the individual probability values;
- the overall probability value is compared with a probability threshold value; and
- the alarm signal is generated when the overall probability value exceeds the probability threshold value.

7. Method according to one of the preceding claims, **characterized in that**

- the protective device (13) identifies a fault in the energy supply network (11, 21a, 21b) by means of a distance protection function; and
- information about the distance of the fault from the measurement point assigned to the protective device (13) is added to the alarm signal, said distance being identified using the distance protection function.

8. Method according to one of Claims 1 to 6, **characterized in that**

- after the occurrence of the fault, fault locating is performed by the protective device (13); and
- information about the determined fault location is added to the alarm signal.

9. Protective device (13) for determining a cause of a fault in an electrical energy supply network (11, 21a, 21b), wherein the protective device (13) has a computing device (32), which is configured

- to perform an examination with respect to the presence of a fault in the electrical energy supply network (11, 21a, 21b) using electrical measurement variables detected at at least one measurement point (12) of the energy supply network (11, 21a, 21b); and
- to generate a fault signal in the event of an identified fault; wherein
- the computing device (32) is configured, after a fault has been identified, to examine time profiles of the measurement variables with respect to the presence of specific criteria, said time profiles having been detected immediately before and/or during the fault, wherein possible causes of faults are assigned to the individual criteria and/or combinations of criteria;
- to determine one or more criteria that are entirely or partially fulfilled by the examined profiles of the measurement variables; and

- to determine a cause of the fault on the basis of the determined criteria and the degree to which they are fulfilled by the profiles,

**characterized in that**

- at least some of the criteria are suitable for identifying deliberately caused faults, wherein a plurality of the following criteria are used as criteria that indicate a deliberately caused fault:
- identification of a permanently present fault;
- identification of repeated, automatic disconnection and connection of a phase of a line within a predefined time period;
- a fault resistance that is below a predefined threshold value; and
- the computing device is configured to generate an alarm signal that indicates a possible line theft, if the check reveals that the fault has been caused deliberately.

**Revendications**

1.  Procédé de détermination de la cause d'un défaut dans un réseau (11, 21a, 21b) d'alimentation en énergie électrique, dans lequel

    - on relève des grandeurs de mesure électriques en au moins un point (12) de mesure du réseau (11, 21a, 21b) d'alimentation en énergie ; et
    - on envoie des grandeurs de mesure électriques à au moins un appareil (13) de protection, qui examine les grandeurs de mesure du point de vue de la présence d'un défaut dans le réseau (11, 21a, 21b) d'alimentation en énergie électrique et, dans le cas où un défaut est reconnu, produit un signal de défaut, dans lequel
    - après qu'un défaut a été reconnu par le au moins un appareil (13) de protection, on examine, du point de vue de la présence de critères définis, les courbes en fonction du temps des grandeurs de mesure relevées juste avant et/ou pendant le défaut, des causes possibles de défaut étant associées aux divers critères et/ou à des combinaisons de critères ;
    - on détermine un critère ou plusieurs critères, qui sont satisfaits en tout ou partie par les courbes des grandeurs de mesure, qui sont examinées ; et
    - en fonction des critères déterminés et du degré de leur satisfaction par les courbes, on détermine une cause du défaut ;
    **caractérisé en ce que**
    - au moins certains des critères sont propres à reconnaître des défaut provoqués intentionnellement, dans lequel
    - comme critères indiquant un défaut provoqué intentionnellement, on utilise plusieurs des critères suivants :

        - la reconnaissance d'un défaut présent en permanence ;
        - la reconnaissance d'une mise hors circuit et d'une mise en circuit automatique répétée d'une phase d'une ligne dans un laps de temps donné à l'avance ;
        - une résistance défectueuse, qui est en dessous d'une valeur de seuil donnée à l'avance ; et
        - dans la mesure où le contrôle montre que le défaut a été provoqué intentionnellement, on produit un signal d'alerte, qui indique l'éventualité d'un vol sur une ligne.

2.  Procédé suivant la revendication 1,
    **caractérisé en ce que**

        - on émet, par le au moins un appareil (13) de protection, un signal, qui indique la cause déterminée.

3.  Procédé suivant l'une des revendications 1 ou 2, **caractérisé en ce que**

        - on utilise, comme critère indiquant un défaut provoqué intentionnellement, un point de coupure reconnu sur une ligne défectueuse.

4.  Procédé suivant la revendication 3,
    **caractérisé en ce que**

        - pour contrôler s'il y a un point de coupure, on examine, pendant une remise en circuit temporaire de la ligne défectueuse, des ondes progressives du courant et/ou de la tension se propageant sur la ligne, dans lequel on reconnaît le point de coupure au point de la ligne où une fonction cible indiquant la courbe de courant le long de la ligne défectueuse a un minimum.

5. Procédé suivant la revendication 4,
**caractérisé en ce que**

- après l'apparition du défaut, on effectue une localisation du défaut et on compare l'emplacement du défaut, qui a été déterminé, à l'emplacement du point de coupure, qui a été déterminé ; et
- on détermine le degré de satisfaction du critère en ce qui concerne un point de coupure présent, en fonction de la distance entre l'emplacement du défaut et la position du point de coupure.

6. Procédé suivant l'une des revendications précédentes,
**caractérisé en ce que**

- à partir du degré de satisfaction respectif des divers critères indiquant un défaut provoqué intentionnellement, on détermine, respectivement, des valeurs de probabilité, qui indiquent la probabilité que la satisfaction du critère respectif signifie effectivement un défaut provoqué intentionnellement ;
- en combinant les diverse valeurs de probabilité, on détermine une valeur de probabilité d'ensemble ;
- on compare la valeur de probabilité d'ensemble à une valeur de seuil de probabilité ; et
- on produit le signal d'alerte, si la valeur de probabilité d'ensemble dépasse la valeur de seuil de probabilité.

7. Procédé suivant l'une des revendications précédentes, **caractérisé en ce que**

- l'appareil (13) de protection reconnaît un défaut dans le réseau (11, 21a, 21b) d'alimentation en énergie au moyen d'une fonction de protection de distance ; et
- on joint au signal d'alerte une information sur la distance, reconnue par la fonction de protection de distance, du défaut au point de mesure associé à l'appareil (13) de protection.

8. Procédé suivant l'une des revendications 1 à 7, **caractérisé en ce que**

- après l'apparition du défaut, il est effectué, par l'appareil (13) de protection, une localisation du défaut ; et
- une information sur l'emplacement du défaut, qui a été déterminé, est jointe au signal d'alerte.

9. Appareil (13) de protection pour déterminer une cause d'un défaut dans un réseau (11, 21a, 21b) d'alimentation en énergie électrique, l'appareil (13) de protection ayant un dispositif (32) de calcul, conçu pour

- en utilisant des grandeurs de mesure électriques relevées en au moins un point (12) de mesure du réseau (11, 21a, 21b) d'alimentation en énergie, effectuer un examen en ce qui concerne la présence d'un défaut dans le réseau (11, 21a, 21b) d'alimentation en énergie électrique ; et
- produire, dans le cas où un défaut est reconnu, un signal de défaut ;
dans lequel
- le dispositif (32) de calcul est conçu pour examiner, après qu'un défaut a été reconnu, des courbes en fonction du temps des grandeurs de mesure, relevées juste avant et/ou pendant le défaut, en ce qui concerne la présence de critères déterminés, des causes possibles de défaut étant associées aux divers critères et/ou à des combinaisons de critères ;
- pour déterminer un ou plusieurs critères, qui sont satisfaits en tout ou partie par les courbes des grandeurs de mesure, qui sont examinées ; et
- en fonction des critères déterminés et du degré de leur satisfaction par les courbes, pour déterminer une cause du défaut,
**caractérisé en ce que** au moins certains des critères sont propres à reconnaître des défauts provoqués intentionnellement, dans lequel on utilise plusieurs des critères suivant, comme critères indiquant un défaut provoqué intentionnellement :

- la reconnaissance d'un défaut présent en permanence ;
- la reconnaissance d'une mise hors circuit et d'une mise en circuit automatique répétée d'une phase d'une ligne dans un laps de temps donné à l'avance ;
- une résistance défectueuse, qui est en dessous d'une valeur de seuil donnée à l'avance ; et
- le dispositif de calcul est conçu pour produire un signal d'alerte, qui indique la possibilité d'un vol sur la ligne, dans la mesure où le contrôle indique que le défaut a été provoqué intentionnellement.

FIG 1

FIG 2

FIG 3

FIG 4

FIG 5

FIG 6

FIG 7

EP 3 293 854 B1

FIG 8

FIG 9

EP 3 293 854 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 9509463 A1
- WO 9736185 A1
- DE 44330406 C1
- EP 2937704 A1
- US 4996624 A
- US 5929642 A